# EUROPEAN PATENT SPECIFICATION

(11) **EP 1 609 174 B1**
(45) Date of publication and mention of the grant of the patent: **30.11.2011**
(21) Application number: 04758931.2
(22) Date of filing: 23.03.2004
(51) Int. Cl.: H01L 21/00

(54) **CHAMBER AND METHOD FOR WAFER PROCESSING**
EINE KAMMER UND EIN VERFAHREN ZUR WAFERHERSTELLUNG
CHAMBRE ET PROCEDE POUR LE TRAITEMENT DE PLAQUETTES

(30) Priority: 31.03.2003 US 404402; 31.03.2003 US 404502; 31.03.2003 US 404472
(43) Date of publication of application: 28.12.2005
(73) Proprietor: LAM RESEARCH CORPORATION, Fremont, CA 94538 (US)
(72) Inventor: PARKS, John, Hercules, CA 94547 (US)
(74) Representative: Kontrus, Gerhard
(86) International application number: PCT/US2004/008994
(87) International publication number: WO 2004/093166

(56) References cited:
- EP-A- 0 408 350
- EP-A- 0 463 853
- EP-A- 0 825 279
- WO-A-00/05750
- WO-A-02/059947
- US-A- 6 024 631
- US-A- 6 032 997
- US-A1- 2003 037 457
- US-A1- 2003 047 551
- US-B1- 6 279 976

## Description

### 1. Field of the Invention

The present invention relates generally to semiconductor wafer processing.

### 2. Description of the Related Art

In the manufacture of semiconductor devices, a surface of a semiconductor wafer ("wafer" or "substrate") must be cleaned to remove chemical and particulate contamination. If the contamination is not removed, semiconductor devices on the wafer may perform poorly or become defective. Particulate contamination generally consists of tiny bits of distinctly defined material having an affinity to adhere to the surface of the wafer. Examples of particulate contamination can include organic and inorganic residues, such as silicon dust, silica, slurry residue, polymeric residue, metal flakes, atmospheric dust, plastic particles, and silicate particles, among others.

Wafer cleaning processes are generally performed by applying a fluid to the surface of the wafer. In some instances the fluid is applied to the wafer in a sealed chamber. The method of applying the fluid to the wafer can influence the effectiveness of the wafer cleaning process. For example, a specific fluid flow pattern over the surface of the wafer may provide beneficial cleaning results. Additionally, a specific fluid pressure applied over the surface of the wafer may provide beneficial cleaning results. Traditionally, different wafer cleaning chambers have been required to obtain different fluid flow patterns and fluid pressures over the surface of the wafer. The need to have a different wafer cleaning chambers to satisfy the requirements of a variety of wafer cleaning processes can present problems with respect to overall wafer processing cost and implementation. Also, wafer cleaning processes that require the use of high fluid pressures generally require the use of large wafer cleaning chambers to withstand the high pressure. Larger wafer cleaning chambers correspond to increased overall wafer processing cost.

In view of the foregoing, there is a need for a wafer cleaning chamber that allows for variable control of fluid pressures and fluid flow patterns as required to meet the needs of different wafer cleaning processes. The wafer cleaning chamber should also be able to accommodate wafers of different sizes. Furthermore, the wafer cleaning chamber should combine an ability to contain high pressures with an overall minimum size.

An important aspect of the chamber design is the method by which the wafer is held or clamped within the chamber. The wafer should be held securely within the chamber to prevent lifting or mobilization of the wafer. With lifting or mobilization, the wafer is exposed to a significant risk of damage. Also, lifting of the wafer will cause the backside of the wafer to be more exposed to cleaning fluids and by-products within the chamber. Exposure of the backside of the wafer to cleaning fluids and by-products can result in increased contamination and cleaning difficulty. Thus, it is important to securely hold the wafer within the chamber during processing.

One conventional option for securing the wafer within the chamber includes clamping the wafer through contact with the wafer top surface. Using clamps in contact with the wafer top surface introduces a potential for causing damage at the clamp-to-wafer interface. Another conventional option for securing the wafer within the chamber includes using an electrostatic chuck to pull the wafer down to a support. Use of an electrostatic chuck can increase the complexity of the chamber design. For example, if the chamber is designed with a pressure boundary, the equipment associated with the electrostatic chuck (e.g., power supply) must be compatible with maintaining the integrity of the pressure boundary. The conventional options for securing the wafer in the chamber can be problematic with respect to wafer damage and implementation complexity, particularly when the chamber incorporates a pressure boundary. To ensure the integrity of the wafer and to simplify the chamber design, it is preferable to secure the wafer within the chamber without the use of clamps contacting the wafer top surface and without the use of an electrostatic chuck.

In view of the foregoing, there is a need for a wafer clamping apparatus that will effectively secure the wafer within the chamber during wafer processing. The wafer clamping apparatus should be implemented without contacting the wafer top surface and with minimal increase in chamber design complexity.

Often, the wafer processing operations need to be performed under high-pressure conditions. Continuing with the wafer cleaning process example, some wafer cleaning processes involve exposing the wafer surface to a supercritical fluid. In such processes, a high-pressure must be provided within a wafer processing volume to maintain the supercritical state of the supercritical fluid. Therefore, a wafer processing module (i.e., chamber) is required to maintain the high-pressure necessary for the wafer processing operation.

In view of the foregoing, there is a need for a high-pressure wafer processing module that can safely interface with a lower pressure wafer transfer module. The high-pressure wafer processing module should be able to accommodate a high-pressure wafer process such as supercritical fluid cleaning.

Further examples of prior art arrangements are disclosed in US 2003/037457 A1, EP 0 825 279 A, WO 00/05750 A, EP-A-0 408 350, EP-A-0 463853 and US-B-6 279 9761.

### SUMMARY OF THE INTENTION

The invention meets the objects of the invention by providing a wafer processing chamber according to claim 1.

Another aspect of the invention is the method for performing a wafer cleaning process according to claim 5.

In one embodiment, a wafer cleaning chamber is disclosed. The wafer cleaning chamber includes a lower support having a number of support surfaces. The lower support contains a first volume that exists between the number of support surfaces. The wafer cleaning chamber further includes a plate supported by the number of support surfaces of the lower support. The plate overlies the first volume in the lower support. The plate also has a number of wafer support surfaces to receive and support a wafer. A second volume exists between the number of wafer support surfaces of the plate. Additionally, inlets and outlets are located in a periphery of the plate for introducing a fluid flow. The inlets and outlets are positioned outside a location intended to receive the wafer. The wafer cleaning chamber also includes an upper support overlying the plate. The upper support interfaces with the lower support at a location outside the periphery of the plate. A third volume within the upper support overlies the wafer to be supported by the plate. The third volume is capable of accommodating a fluid flow. The fluid flow can be introduced in a set configuration by the inlets and outlets of the plate. Also, the third volume is in limited fluid communication with the first volume and the second volume.

In another embodiment, a wafer processing apparatus is disclosed. The wafer processing apparatus includes a chamber having an upper portion and a lower portion. Support structures are distributed within a first volume that is defined in the lower portion of the chamber. Also, additional support structures are distributed within a second volume that is defined within the upper portion of the chamber. The wafer processing apparatus further includes a lower plate that is configured to be disposed on the support structures of the lower portion of the chamber. When disposed on the support structures, the lower plate overlies the first volume within the lower portion of the chamber. The lower plate includes a number of wafer support structures distributed within a third volume defined within the lower plate. The number of wafer support structures are capable of supporting a wafer. When the wafer is placed on the wafer support structures, the wafer overlies the third volume within the lower plate. The wafer processing apparatus also includes an upper plate configured to be attached to the support structures of the upper portion of the chamber. When the upper plate is attached to the support structures, the upper plate underlies the second volume defined within the upper portion of the chamber. The upper plate serves as an upper boundary of a fourth volume that exists between the upper plate and the wafer to be supported by the lower plate. The fourth volume is capable of containing a fluid. Also, the fourth volume is in limited fluid communication with the first volume, the second volume, and the third volume.

In another embodiment, a method for making a wafer processing chamber is disclosed. The method includes forming a lower support plate that has support surfaces distributed within a first volume that is defined within the lower support plate. The first volume is defined to have a first fluid inlet and a first fluid outlet. The method also includes forming a wafer support plate having wafer support surfaces distributed within a second volume that is defined within the wafer support plate. The wafer support surfaces are configured to receive a wafer. Once received, the wafer forms an upper boundary for the second volume defined within the wafer support plate. The second volume is defined to have a second fluid inlet and a second fluid outlet. Additionally, fluid inlets and fluid outlets are provided at a periphery of the wafer support plate and outside a location that is to receive the wafer. The method further includes securing the wafer support plate to the lower support plate. Once secured, the wafer support plate is supported by the support surfaces distributed within the first volume of the lower support plate. Also, the wafer support plate serves as an upper boundary for the first volume defined within the lower support plate. The method continues with the forming of an upper support plate that contains a third volume configured to overlie the wafer to be received by the wafer support surfaces of the wafer support plate. The method also includes securing the upper support plate to the lower support plate to isolate the third volume defined within the upper support plate from an outside environment. The isolation of the third volume from the outside environment is enabled by a seal disposed between the upper support plate and the lower support plate.

In another embodiment, a method for performing a wafer cleaning process is disclosed. The method includes providing a chamber in which the wafer cleaning process can be performed. The chamber includes a first volume configured to overlie a wafer to be cleaned. The chamber also includes a plate configured to support the wafer. A second volume is defined within the plate directly below the wafer. Also in the chamber, a support structure is provided to support the plate. The support structure includes a third volume located directly below the plate. The method further includes pressurizing the first volume to have a higher pressure than the second volume. The method also includes pressurizing the second volume to have a higher pressure than the third volume. The third volume is pressurized to have a pressure between that of the second volume and an environment outside the chamber. Also in the method, a fluid is provided to the first volume that overlies the wafer to be cleaned. The fluid is formulated to effect the wafer cleaning process.

In another embodiment, a wafer clamping apparatus is disclosed. The wafer clamping apparatus includes a wafer support structure having a number of wafer support surfaces. A lower volume is defined within the wafer support structure between the number of wafer support surfaces. The lower volume exists below a wafer to be disposed on the number of wafer support surfaces. The wafer clamping apparatus also includes an upper volume defined above the wafer to be disposed on the number of wafer support surfaces. An evacuation source is configured to de-pressurize the lower volume. De-pressurization of the lower volume causes a pressure in the upper volume to be higher than a pressure in the lower volume. The lower pressure in the lower volume causes the wafer to remain disposed on the number of wafer support surfaces.

In another embodiment, a wafer processing chamber is disclosed. The wafer processing chamber includes a lower plate configured to receive a wafer. The lower plate has a number of wafer support structures dispersed within a volume configured to underlie the wafer. The wafer processing chamber also includes an upper plate overlying the lower plate. The upper plate has an overlying volume configured to overlie the wafer to be received by the lower plate. An inlet for supplying a fluid to the overlying volume is also provided. The fluid supplied from the inlet is capable of pressurizing the overlying volume. Also, the fluid is capable of entering the underlying volume by traversing between the lower plate and the wafer to be received by the lower plate. The wafer processing chamber also includes an outlet for controlling the pressure in the underlying volume. The outlet is capable of being controlled to cause a pressure in the underlying volume to be lower than a pressure in the overlying volume. The lower pressure in the underlying volume causes the wafer to be forced toward the lower plate.

In another embodiment, a method for clamping a wafer using pressure control is disclosed. In the method, a wafer is disposed on a wafer support. The method further includes decreasing a pressure below the wafer to be lower than a pressure above the wafer. The decreased pressure below the wafer serves to hold the wafer toward the wafer support.

In another embodiment, a wafer processing chamber is disclosed. The wafer processing chamber includes an upper section that is secured in an immobile state. The upper section includes both a pathway for receiving a wafer and a bottom opening. Also in the wafer processing chamber, a lower section is provided to be moved through the bottom opening of the upper section. Correspondingly, the lower section is connected to a movement mechanism. The wafer processing chamber further includes a first seal and a second seal. The first seal is disposed between the lower section and the upper section within the bottom opening of the upper section. The second seal is disposed on a top surface of the lower section. The second seal is configured to be enabled through contact with both the upper section and the lower section. The second seal encloses a periphery of a wafer processing volume when in contact with both the upper section and the lower section.

In another embodiment, another version of a wafer processing chamber is disclosed. The wafer processing chamber includes a lower section that is secured in an immobile state. The lower section includes both a pathway for receiving a wafer and a top opening. Also in the wafer processing chamber, an upper section is provided to be moved through the top opening of the lower section. Correspondingly, the upper section is connected to a movement mechanism. The wafer processing chamber further includes a first seal and a second seal. The first seal is disposed between the upper section and the lower section within the top opening of the lower section. The second seal is disposed on a top surface of the lower section and within the top opening of the lower section. The second seal is configured to be enabled through contact with both the lower section and the upper section. The second seal encloses a periphery of a wafer processing volume when in contact with both the lower section and the upper section.

In another embodiment, a method for making a wafer processing chamber is disclosed. The method includes providing both a chamber upper section and a chamber lower section. The chamber upper section and the chamber lower section are configured to be movable with respect to each other. The method further includes providing a first seal between the chamber upper section and the chamber lower section. The first seal serves to isolate a chamber outer volume from an outside environment. Additionally in the method, a second seal is provided between the chamber upper section and the chamber lower section. The second seal is configured to enclose a periphery of a wafer processing volume. Also, the second seal serves to isolate the wafer processing volume from the chamber outer volume. The second seal is enabled through contact with both the chamber upper section and the chamber lower section. Other aspects and advantages of the invention will become more apparent from the following detailed description, taken in conjunction with the accompanying drawings, illustrating by way of example the present invention.

### BRIEF DESCRIPTION OF THE DRAWINGS

The invention, together with further advantages thereof, may best be understood by reference to the following description taken in conjunction with the accompanying drawings in which:
Figure 1 is an illustration showing a vertical cross-section of a wafer processing chamber ("chamber"), in accordance with one embodiment of the present invention;
Figure 2 is an illustration showing a close-up view of a central portion of the chamber as shown in Figure 1, in accordance with one embodiment of the present invention;
Figure 3 is an illustration showing a top view of the lower plate configured to provide a linear fluid flow across the wafer, in accordance with one embodiment of the present invention;
Figure 4 is an illustration showing a top view of the lower plate configured to provide a conical fluid flow across the wafer, in accordance with one embodiment of the present invention;
Figure 5 is an illustration showing a top view of the lower plate configured to provide a spiral fluid flow across the wafer, in accordance with one embodiment of the present invention;
Figure 6 is an illustration showing a vertical cross-section of the chamber incorporating an upper plate, in accordance with one embodiment of the present invention;
Figure 7 is an illustration showing a close-up view of a central portion of the chamber as shown in Figure 6, in accordance with one embodiment of the present invention;
Figure 8A is an illustration showing an upper plate configured to provide a central fluid feed and a peripheral fluid exhaust, in accordance with one embodiment of the present invention;
Figure 8B is an illustration showing the use of fluid channels within the upper plate, in accordance with one embodiment of the present invention;
Figure 9 is an illustration showing an upper plate configured to provide a peripheral fluid feed and a central fluid exhaust, in accordance with one embodiment of the present invention;
Figure 10 is an illustration showing an exemplary distribution of the inlets/outlets across the upper plate, in accordance with one embodiment of the present invention;
Figure 11 is an illustration showing a flowchart of a method for making a wafer processing chamber, in accordance with one embodiment of the present invention;
Figure 12 is an illustration showing a flowchart of a method for performing a wafer cleaning process, in accordance with one embodiment of the present invention;
Figure 13 is an illustration showing a generalized material phase diagram;
Figure 14 is an illustration showing a cross-section view of a wafer processing chamber, in accordance with one embodiment of the present invention;
Figure 15 is an illustration showing close-up view of the interface between the upper plate and the lower plate, in accordance with one embodiment of the present invention;
Figure 16 is an illustration showing a plan view of the lower support plate, in accordance with one embodiment of the present invention;
Figure 17 is an illustration showing a plan view of the lower plate, in accordance with one embodiment of the present invention;
Figure 18 is an illustration showing a plan view of the upper plate, in accordance with one embodiment of the present invention;
Figure 19 is an illustration showing a fluid flow system associated with the wafer clamping apparatus, in accordance with one embodiment of the present invention;
Figure 20 is an illustration showing a flowchart of a method for clamping a wafer using active and independent pressure control both above and below the wafer, in accordance with one embodiment of the present invention;
Figure 21 is an illustration showing a flowchart of a method for clamping a wafer using active pressure control above the wafer and controlled venting below the wafer, in accordance with one embodiment of the present invention;
Figure 22 is an illustration showing a wafer processing chamber in an open state, in accordance with one embodiment of the present invention;
Figure 23 is an illustration showing the chamber in a closed state, in accordance with one embodiment of the present invention;
Figure 24 is an illustration showing a wafer processing chamber in an open state, in accordance with one embodiment of the present invention;
Figure 25 is an illustration showing the chamber in a closed state, in accordance with one embodiment of the present invention; and
Figure 26 is an illustration showing a flowchart of a method for making a wafer processing chamber, in accordance with one embodiment of the present invention.

### DETAILED DESCRIPTION

In one embodiment of the present invention, a chamber is provided that allows a fluid flow and a fluid pressure within the chamber to be controlled in a variable manner. More specifically, in the present embodiment, the chamber utilizes removable plates that can be configured to control the fluid flow and the fluid pressure in an inner volume within the chamber. Also, the removable plates can be used to separate the inner volume within the chamber from an outer volume within the chamber. In this manner, the removable plates can be used to create a pressure differential between the inner volume within the chamber and the outer volume within the chamber. A lower pressure in the outer volume within the chamber requires less outer chamber strength to withstand the lower pressure. A lower outer chamber strength requirement translates into an overall decrease in chamber size.

Another embodiment of the present invention provides a wafer clamping apparatus capable of securing a wafer within a chamber during wafer processing. More specifically, the wafer clamping apparatus creates a pressure differential between a top surface and a bottom surface of the wafer. The pressure differential serves to pull the wafer toward a wafer support structure in contact with the wafer bottom surface, whereby the wafer is secured and maintained in an immobile state. The wafer clamping apparatus also includes options for controlling the pressure differential between the top and bottom surfaces of the wafer. One option involves actively and independently controlling both a pressure above the wafer and a pressure below the wafer. Another option involves actively controlling the pressure above the wafer while venting the pressure below the wafer, wherein the venting can be passively or actively controlled. The wafer clamping apparatus is implemented without requiring contact with the wafer top surface and with minimal increase in chamber design complexity.

In yet another embodiment, a wafer processing chamber is provided for performing a high-pressure wafer process. More specifically, the high-pressure wafer processing chamber configuration incorporates a wafer processing volume and an outer chamber volume. The wafer processing volume is configured to contain a high pressure. The outer chamber volume is configured to serve as a buffer between the high pressure of the wafer processing volume and a lower pressure of an environment outside the wafer processing chamber. Thus, the outer chamber volume can control a pressure differential between the higher pressure wafer processing volume and the lower pressure outside environment. In this manner, the wafer processing chamber, incorporating the high-pressure wafer processing volume, can interface with a conventional wafer transfer module operating under either atmospheric or sub-atmospheric pressure conditions.

In the following description, numerous specific details are set forth in order to provide a thorough understanding of the present invention. It will be apparent, however, to one skilled in the art that the present invention may be practiced without some or all of these specific details. In other instances, well known process operations have not been described in detail in order not to unnecessarily obscure the present invention.

### Variable Configuration Chamber

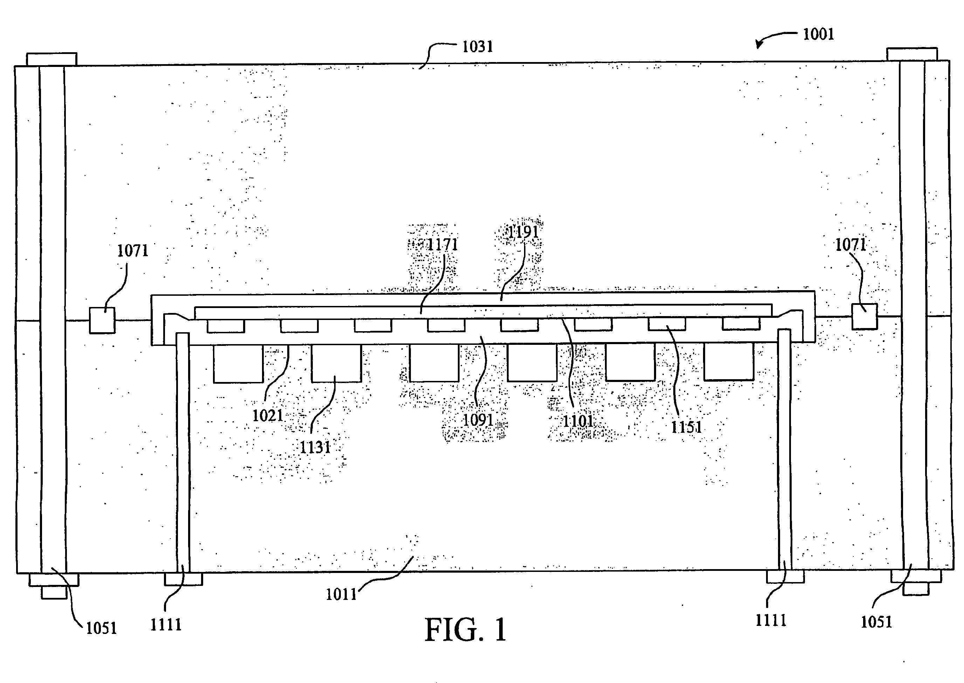

Figure 1 is an illustration showing a vertical cross-section of a wafer processing chamber ("chamber") 1001, in accordance with one embodiment of the present invention. In one embodiment, the chamber 1001 can serve as a wafer cleaning chamber. The chamber 1001 includes a lower support plate 1011 having a number of support surfaces 1021. The support surfaces 1021 are distributed within an intermediate volume 1131 defined within a top portion of the lower support plate 1011. The support surfaces 1021 are capable of supporting a lower plate 1091 at discrete locations in a substantially uniform manner. The number and location of the support surfaces 1021 depends on a pressure differential between the two sides of the lower plate 1091. When placed on the support surfaces 1021, the lower plate 1091 serves as an upper boundary to the intermediate volume 1131.

The lower plate 1091 can be secured to the lower support plate 1011 by a number of bolts 1111. The lower plate 1091 includes a number of wafer support surfaces 1101 distributed to provide substantially uniform support to a wafer 1171 to be disposed within the chamber 1001. The lower plate 1091 can be sized to allow the chamber 1001 to process wafers of different sizes (e.g., 200 mm diameter, 300 mm diameter, etc...). The wafer support surfaces 1101 are separated to form a lower volume 1151. The lower volume 1151 is located beneath the wafer 1171 to be disposed on the lower plate 1091. Hence, with respect to the wafer 1171, the lower volume 1151 is also referred to as an underlying volume 1151.

The chamber 1001 also includes an upper support plate 1031 that is configured to interface with a top section of the lower support plate 1011. The upper support plate 1031 includes a wafer processing volume 1191. The wafer processing volume 1191 is configured to overlie the wafer 1171 when the upper support plate 1031 is attached to the lower support plate 1011. When the wafer 1171 is present in the chamber 1001, the top surface of the wafer 1171 is exposed to the wafer processing volume 1191. Hence, with respect to the wafer 1171, the wafer processing volume 1191 is also referred to as an overlying volume 1191.

A seal 1071 is disposed between the upper support plate 1031 and the lower support plate 1011 at a peripheral location where the upper support plate 1031 and the lower support plate 1011 are in contact. The seal 1071 traverses the periphery of the wafer processing volume 1191 and serves to isolate the wafer processing volume 1191 from an outside environment. To enable the seal 1071, the upper support plate 1031 and lower support plate 1011 are forced together by a number of bolts 1051 located outside a periphery of the seal 1071. Some wafer processes must be performed at extremely high pressures. Thus, the upper support plate 1031, the lower support plate 1011, and the bolts 1051 provide sufficient strength to withstand a pressure which may exist within the wafer processing volume 1191.

Additionally, some wafer processes must be performed at specific temperatures. In order to provide temperature control within the wafer processing volume 1191, thermal control devices can be disposed within the upper support plate 1031 and the lower support plate 1011. In one embodiment, the thermal control devices can include heat exchanger fluid pathways. In another embodiment, the thermal control devices can include electric heating elements. In either embodiment, conduction through the upper support plate 1031, the lower support plate 1011, and the lower plate 1091 provide a transfer mechanism to move heat from the thermal control devices to the wafer processing volume 1191.

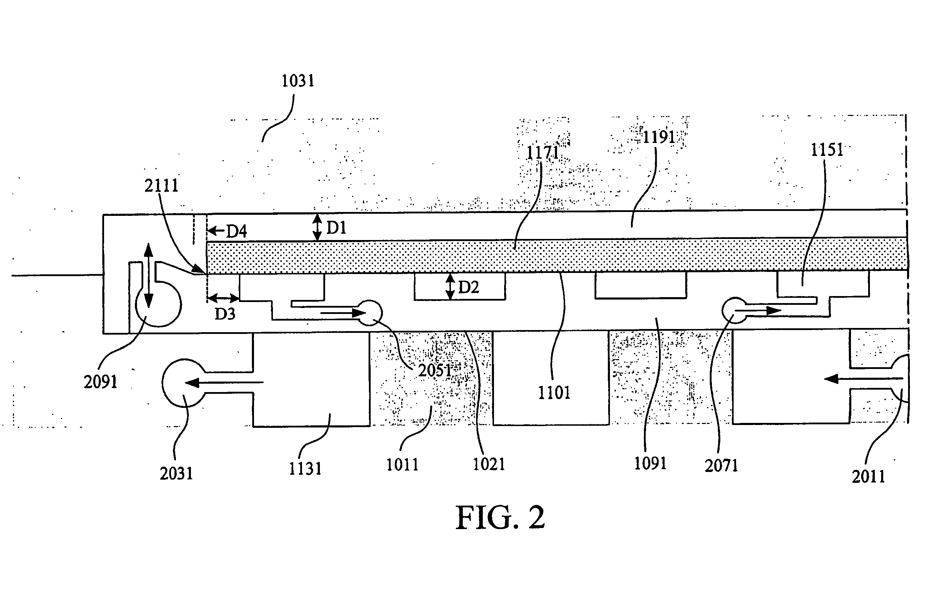

Figure 2 is an illustration showing a close-up view of a central portion of the chamber 1001 as shown in Figure 1, in accordance with one embodiment of the present invention. The close-up view shows a vertical cross-section of half of the chamber 1001, including the upper support plate 1031, the wafer processing volume 1191, the wafer 1171, the underlying volume 1151, the lower plate 1091, the intermediate volume 1131, and the lower support plate 1011.

As discussed with respect to Figure 1, the lower plate 1091 serves to support the wafer 1171 by providing the wafer support surfaces 1101 upon which the wafer 1171 will be secured during wafer processing. Each of the wafer support surfaces 1101 is a part of a discrete support structure. The discrete support structures corresponding to the wafer support surfaces 1101 are distributed in a substantially uniform manner throughout the underlying volume 1151. Therefore, the underlying volume 1151 exists between the discrete support structures corresponding to the wafer support surfaces 1101 and below the wafer 1171. An inlet 2071 is provided for introducing fluids into the underlying volume 1151. An outlet 2051 is provided for removing fluids from the underlying volume 1151. In other embodiments, the inlet 2071 and the outlet 2051 can be disposed at other locations within the lower plate 1091. A number of inlets/outlets 2091 are also provided within the lower plate 1091 to introduce and remove fluids from the wafer processing volume 1191.

As discussed with respect to Figure 1, the lower support plate 1011 serves to support the lower plate 1091 by providing the support surfaces 1021 upon which the lower plate 1091 will be secured during wafer processing. Each of the support surfaces 1021 is a part of a discrete support structure. The discrete support structures corresponding to the support surfaces 1021 are distributed in a substantially uniform manner throughout the intermediate volume 1131. Therefore, the intermediate volume 1131 exists between the discrete support structures corresponding to the support surfaces 1021 and below the lower plate 1091. An inlet 2011 is provided for introducing fluids into the intermediate volume 1131. An outlet 2031 is provided for removing fluids from the intermediate volume 1131. In other embodiments, the inlet 2011 and the outlet 2031 can be disposed at other locations within the lower support plate 1011.

The wafer processing volume 1191 is formed within the upper support plate 1031 to overlie the wafer 1171 when the upper support plate 1031 is joined with the lower support plate 1011. Since the wafer 1171 is not hermetically sealed to the lower plate 1091 during wafer processing, the wafer processing volume 1191 will be in fluid communication with the underlying volume 1151 through a limited fluid communication pathway 2111 at the periphery of the wafer 1171. The limited fluid communication pathway 2111 is essentially the area between the wafer 1171 and the peripheral wafer support surface 1101 of the lower plate 1091.

During operation, a pressure in the wafer processing volume 1191 will be maintained at a higher level than a pressure in the underlying volume 1151, thus creating a pressure differential through the wafer 1171 from top to bottom. The pressure differential serves to push the wafer 1171 toward the lower plate 1091 with sufficient force to secure the wafer 1171 to the wafer support surfaces 1101. Since the pressure in the wafer processing volume 1191 is higher than the pressure in the underlying volume 1151, some fluid will pass from the wafer processing volume 1191 through the limited fluid communication pathway 2111 to the underlying volume 1151. The outlet 2051 can be used to remove fluid from the underlying volume 1151 as necessary.

The dimensions of the wafer processing volume 1191, the underlying volume 1151, and the wafer support surfaces 1101 can vary depending upon the requirements (e.g., pressure, fluid flow rate, fluid composition, etc...) of the wafer process to be performed. In one embodiment, a separation distance D1 between the upper support plate 1031 and the wafer 1171 top surface is about 1 mm (0.04 inch). As used herein, the term "about" means within ± 10% of a specified value. However, in other embodiments different values for D1 may be used. In one embodiment, a depth D2 of the underlying volume 1151 between the wafer 1171 and the lower plate 1091 can be within a range extending from about 0,13 mm (0.005) inch to about 1 mm (0.04 inch). In a particular embodiment, the depth D2 is about 0,5 mm (0.20 inch). In one embodiment, an overlap distance D3 between the wafer 1171 and the peripheral wafer support surface 1101 can be within a range extending from about 2,5 mm (0.1 inch) to about 12,7 mm (0.5 inch). In a particular embodiment, the overlap distance D3 is about 6,35 mm (0.25 inch). The overlap distance D3 is a key factor in establishing the pressure drop between the wafer processing volume 1191 and the underlying volume 1151, through the limited fluid communication pathway 2111. In one embodiment, a wafer positioning tolerance D4 (i.e., nominal distance between the wafer 1171 edge and a about 0,64 mm (0.025 inch) to about 2,5 mm (0.1 inch).The wafer positioning tolerance D4 may be dictated by a precision of a robot handling device.

The wafer support surfaces 1101 are configured to contact a percentage of the wafer 1171 commensurate with the pressure differential to be applied through the wafer 1171. A higher pressure differential requires a higher percentage of the wafer 1171 to be in contact with the wafer support surfaces 1101. In one embodiment, the wafer support surfaces 1101 can be in contact with a percentage of the wafer 1171 surface within a range extending from about 5% to about 80%. In another embodiment, the wafer support surfaces 1101 can be in contact with a percentage of the wafer 1171 surface within a range extending from about 15% to about 25%. In yet another embodiment, the wafer support surfaces 1101 can be in contact with about 20% of the wafer 1171 surface. With a differential pressure within a range extending from about 1 atm to about 1.5 atm, the wafer support surfaces 1101 can be in contact with a percentage of the wafer 1171 surface within a range extending up to about 10%. With a differential pressure within a range extending from about 3 atm to about 4 atm, the wafer support surfaces 1101 can be in contact with a percentage of the wafer 1171 surface within a range extending from about 50% to about 70%.

It is preferable to minimize the percentage of the wafer 1171 in contact with the wafer support surfaces 1101 (i.e., wafer backside contact area). Minimization of the wafer backside contact area, however, should be performed in a manner that provides sufficient support for the particular pressure differential to be applied between the wafer processing volume 1191 and the underlying volume 1151. Minimizing the wafer backside contact area serves to reduce the potential for wafer 1171 contamination. Also, minimizing the wafer backside contact area reduces the potential for particles becoming lodged between the wafer 1171 and the wafer support surfaces 1101, which could cause difficulty in securing the wafer 1171.

Pressures in each of the wafer processing volume 1191, the underlying volume 1151, and the intermediate volume 1131 can be controlled independently by controlling fluid introduction to and removal from each volume. The lower plate 1091 allows the wafer processing volume 1191 pressure to be adjusted relative to the intermediate volume 1131 pressure. In this manner, the lower plate 1091 allows a high pressure to be constrained within the wafer processing volume 1191. In an alternate embodiment, the intermediate volume 1131 can be over-pressurized to cause a fluid to be introduced into the wafer processing volume 1191 from the intermediate volume 1131. Regardless, of the particular embodiment, however, the pressure differential between the two sides of the lower plate 1091 dictates the required thickness of the lower plate 1091. A larger pressure differential across the lower plate 1091 requires the lower plate 1091 to have a larger thickness. For the lower plate 1091 to be thinner, the pressure differential between the wafer processing volume 1191 and the intermediate volume 1131 should be lower.

It is desirable to minimize the thickness of the lower plate 1091 in order to reduce the volume of outer chamber 1001 material and the chamber 1001 overall size. However, a balance exists when determining the lower plate 1091 thickness to use and the minimum intermediate volume 1131 pressure to allow. A thinner lower plate 1091 will reduce the overall chamber 1001 size, but a lower intermediate volume 1131 pressure will allow the use of a thinner lower support plate 1011, by reducing a pressure differential between the intermediate volume 1131 and an outside environment.

With an effective variation in pressure differential from the wafer processing volume 1191 to the intermediate volume 1131 to the outside environment, the chamber 1001 size can be optimized. Thus, the use of multiple chamber internal volumes allows for a more compact chamber 1001 design. Also, minimizing the size of the wafer processing volume 1191 allows both the chamber size and the wafer processing cycle time to be reduced. A smaller wafer processing volume 1191 requires less material to constrain the pressure within the wafer processing volume 1191. Furthermore, a smaller wafer processing volume 1191 requires less time to reduce the high pressure within the wafer processing volume 1191 to a pressure at which the wafer 1171 can be safely transferred, thus reducing the wafer processing cycle time.

As previously mentioned, the lower plate 1091 includes the number of inlets/outlets 2091 for introducing fluids to and removing fluids from the wafer processing volume 1191. The inlets/outlets 2091 are located near the periphery of the lower plate 1091 and outside a location intended to receive the wafer 1171. The inlets/outlets 2091 can be configured to control a fluid flow through the wafer processing volume 1191 over a top surface of the wafer 1171. It is likely that different fluid flow patterns and pressures will work better for different wafer processing applications. The inlets/outlets 2091 in the lower plate 1091 can be configured to provide numerous fluid flow patterns within the wafer processing volume 1191. In following, numerous lower plates 1091 can be designed and manufactured to provide a selection of fluid flow patterns, thus allowing a suitable fluid flow pattern to be selected for a specific wafer process. Since the lower plates 1091 are interchangeable, the fluid flow pattern through the wafer processing volume 1191 can be changed without requiring other aspects of the chamber 1001, beyond the lower plate 1091, to be altered.

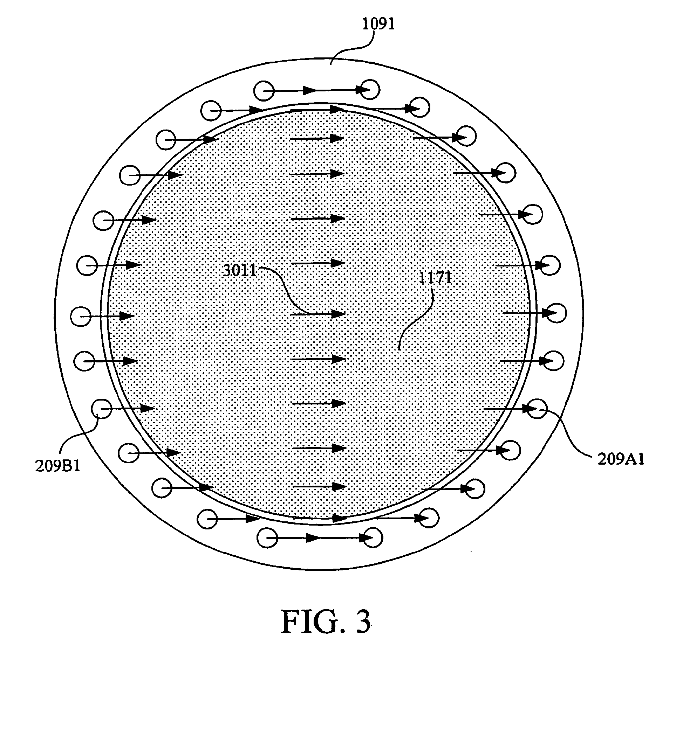

Figure 3 is an illustration showing a top view of the lower plate 1091 configured to provide a linear fluid flow across the wafer 1171, in accordance with one embodiment of the present invention. The lower plate 1091 is defined to have a number of inlets 209B1 distributed in a substantially uniform manner around a 180 degree segment of the lower plate 1091 periphery. The lower plate 1091 is further defined to have a number of outlets 209A1 distributed in a substantially uniform manner around a 180 degree segment of the lower plate 1091 periphery that is opposite the 180 degree segment containing the number of inlets 209B1. The fluid is introduced into the wafer processing volume 1191 through the number of inlets 209B1. The fluid is removed from the wafer processing volume 1191 through the number of outlets 209A1. The disposition of the number of inlets 209B1 and the number of outlets 209A1 causes the fluid to flow in a linear pattern across the top surface of the wafer 1171 as indicated by arrows 301.

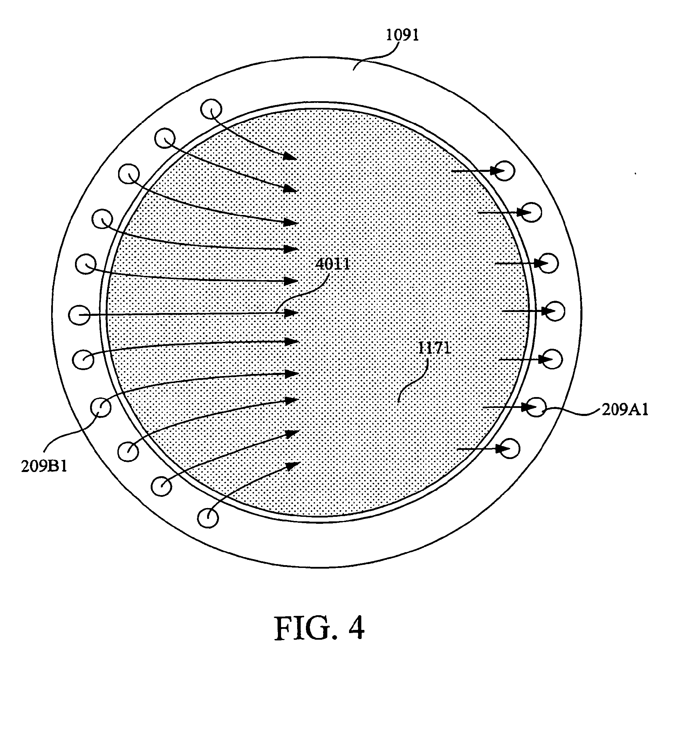

Figure 4 is an illustration showing a top view of the lower plate 1091 configured to provide a conical fluid flow across the wafer 1171, in accordance with one embodiment of the present invention. The lower plate 1091 is defined to have a number of inlets 209B1 distributed in a substantially uniform manner around a segment of the lower plate 1091 periphery that subtends an angle less than 180 degrees. The lower plate 1091 is further defined to have a number of outlets 209A1 distributed in a substantially uniform manner around a segment of the lower plate 1091 periphery that subtends an angle less than that subtended by the number of inlets 209B1. The number of outlets 209A1 are positioned at a location opposite the number of inlets 209B1. The fluid is introduced into the wafer processing volume 1191 through the number of inlets 209B1. The fluid is removed from the wafer processing volume 1191 through the number of outlets 209A1. The disposition of the number of inlets 209B1 and the number of outlets 209A1 causes the fluid to flow in a conical pattern across the top surface of the wafer 1171 as indicated by arrows 4011. The conical pattern can be optimized to allow the fluid flow to maintain a constantly accelerating velocity across the top surface of the wafer 1171.

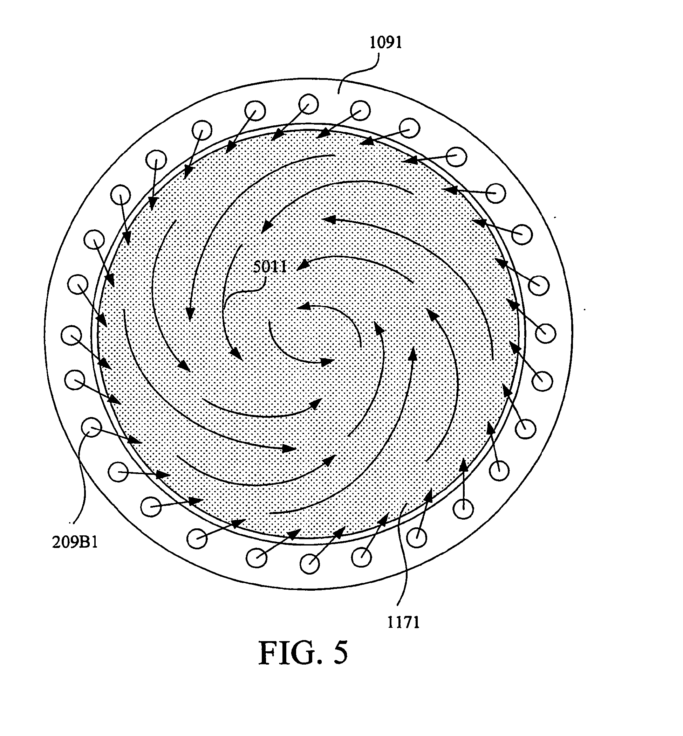

Figure 5 is an illustration showing a top view of the lower plate 1091 configured to provide a spiral fluid flow across the wafer 1171, in accordance with one embodiment of the present invention. The lower plate 1091 is defined to have a number of inlets 209B1 distributed in a substantially uniform manner around the lower plate 1091 periphery. The fluid is introduced into the wafer processing volume 1191 through the number of inlets 209B1. The number of inlets 209B1 are configured to direct the fluid in a tangential direction with respect to the wafer 1171. The configuration of the number of inlets 209B1 causes the fluid to flow in a spiral pattern across the top surface of the wafer 1171 as indicated by arrows 5011. In one embodiment, the fluid is removed from the wafer processing volume 1191 through one or more outlets located in the upper support plate 1031.

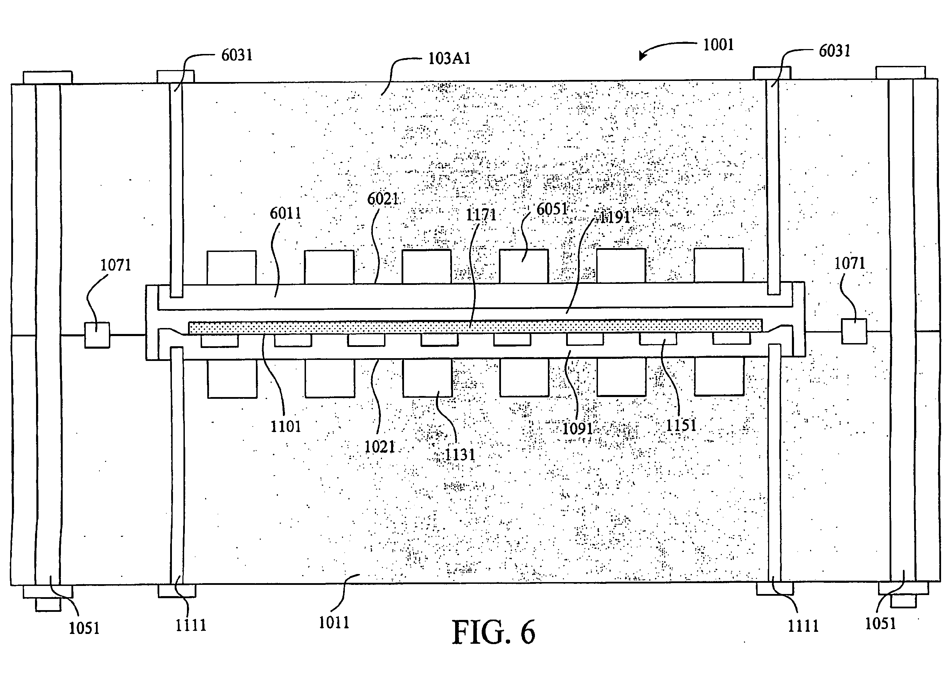

Figure 6 is an illustration showing a vertical cross-section of the chamber 1001 incorporating an upper plate 6011, in accordance with one embodiment of the present invention. The chamber 1001 incorporates the lower plate 1091, the lower support plate 1011, the bolts 1111, the bolts 1051, and the seal 1071 as previously described with respect to Figure 1. The chamber 1001 embodiment illustrated in Figure 6, however, incorporates a different upper support plate 103A1.

The upper support plate 103A1 is configured to interface with the top section of the lower support plate 1011. The upper support plate 103A1 includes a number of support surfaces 6021. The support surfaces 6021 are distributed within an intermediate volume 6051 defined within a bottom portion of the upper support plate 103A1. The support surfaces 6021 are capable of supporting the upper plate 6011 at discrete locations in a substantially uniform manner. The number and location of the support surfaces 6021 depends on a pressure differential between the two sides of the upper plate 6011. The upper plate 6011 can be secured to the upper support plate 103A1 by a number of bolts 6031. When secured to the upper support plate 103A1, the upper plate 6011 serves as a lower boundary to the intermediate volume 6051.

The upper support plate 103A1 further includes the wafer processing volume 1191. The wafer processing volume 1191 is configured to overlie the wafer 1171 when the upper support plate 103A1 is attached to the lower support plate 1011. The wafer processing volume 1191 is also configured to underlie the upper plate 6011 when the upper plate 6011 is secured to the upper support plate 103A1. In this manner, the upper plate 6011 serves as an upper boundary to the wafer processing volume 1191.

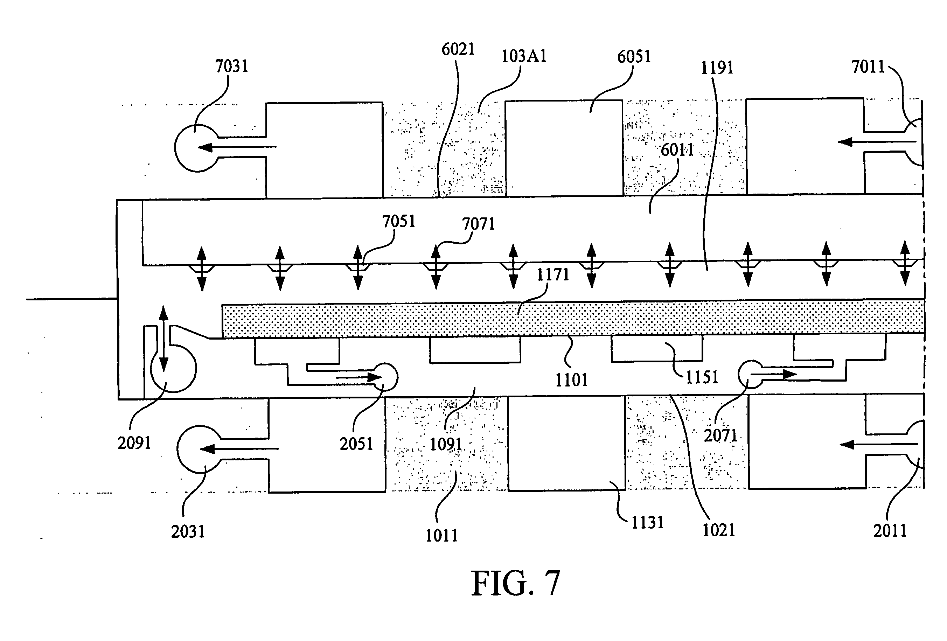

Figure 7 is an illustration showing a close-up view of a central portion of the chamber 1001 as shown in Figure 6, in accordance with one embodiment of the present invention. The close-up view shows a vertical cross-section of half of the chamber 1001, including the upper support plate 103A1, the upper plate 6011, the intermediate volume 6051, the wafer processing volume 1191, the wafer 1171, the underlying volume 1151, the lower plate 1091, the intermediate volume 1131, and the lower support plate 1011.

The lower plate 1091, having the wafer support surfaces 1101 distributed within the underlying volume 1151 and containing the inlet 2071, the outlet 2051 and the inlet/outlet 2091, is the same as previously described with respect to Figure 2. Also, the lower support plate 1011, having the support surfaces 1021 distributed within the intermediate volume 1131 and containing the inlet 2011 and the outlet 2031, is the same as previously described with respect to Figure 2.

As discussed with respect to Figure 6, the upper support plate 103A1 serves to support the upper plate 6011 by providing the support surfaces 6021 upon which the upper plate 6011 will be secured during wafer processing. Each of the support surfaces 6021 is a part of a discrete support structure. The discrete support structures corresponding to the support surfaces 6021 are distributed in a substantially uniform manner throughout the intermediate volume 6051. Therefore, the intermediate volume 6051 exists between the discrete support structures corresponding to the support surfaces 6021 and above the upper plate 6011. An inlet 7011 is provided for introducing fluids into the intermediate volume 6051. An outlet 7031 is provided for removing fluids from the intermediate volume 6051. In other embodiments, the inlet 7011 and the outlet 7031 can be disposed at other locations within the upper support plate 103A1.

Pressures in each of the wafer processing volume 1191 and the intermediate volume 6051 can be controlled independently by controlling fluid introduction to and removal from each volume. The upper plate 6011 allows the wafer processing volume 1191 pressure to be adjusted relative to the intermediate volume 6051 pressure. In this manner, the upper plate 6011 allows a high pressure to be constrained within the wafer processing volume 1191. In an alternate embodiment, the intermediate volume 6051 can be over-pressurized to cause a fluid to be introduced into the wafer processing volume 1191 from the intermediate volume 6051. Regardless, of the particular embodiment, however, the pressure differential between the two sides of the upper plate 6011 dictates the required thickness of the upper plate 6011. A larger pressure differential across the upper plate 6011 requires the upper plate 6011 to have a larger thickness. For the upper plate 6011 to be thinner, the pressure differential between the wafer processing volume 1191 and the intermediate volume 6051 should be lower.

It is desirable to minimize the thickness of the upper plate 6011 in order to reduce the volume of outer chamber 1001 material and the chamber 1001 overall size. However, a balance exists when determining the upper plate 6011 thickness to use and the minimum intermediate volume 6051 pressure to allow. A thinner upper plate 6011 will reduce the overall chamber 1001 size, but a lower intermediate volume 6051 pressure will allow the use of a thinner upper support plate 103A1, by reducing a pressure differential between the intermediate volume 6051 and an outside environment. With an effective variation in pressure differential from the wafer processing volume 1191 to the intermediate volume 6051 to the outside environment, the chamber 1001 size can be optimized.

The upper plate 6011 includes a number of inlets/outlets 7051 for introducing fluid to and removing fluid from the wafer processing volume 1191, as indicated by arrows 7071. The inlets/outlets 7051 are distributed across the upper plate 6011 and are configured to control the fluid flow through the wafer processing volume 1191 over the top surface of the wafer 1171. As previously mentioned, it is likely that different fluid flow patterns and pressures will work better for different wafer processing applications. The inlets/outlets 7051 in the upper plate 6011 can be configured to provide numerous fluid flow patterns within the wafer processing volume 1191. Additionally, the inlets/outlets 7051 in the upper plate 6011 can be configured to work in conjunction with the inlets/outlets 2091 in the lower plate 1091 to provide fluid flow patterns within the wafer processing volume 1191. In following, numerous upper plates 6011 can be designed and manufactured to provide a selection of fluid flow patterns, thus allowing a suitable fluid flow pattern to be selected for a specific wafer process. As with the lower plates 1091, the interchangeability of the upper plates 6011 allows the fluid flow pattern through the wafer processing volume 1191 to be changed without requiring other aspects of the chamber 1001 to be changed.

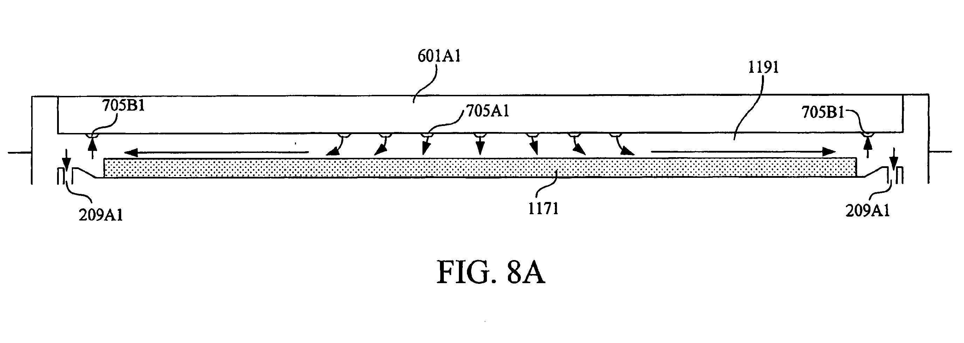

Figure 8A is an illustration showing an upper plate 601A1 configured to provide a central fluid feed and a peripheral fluid exhaust, in accordance with one embodiment of the present invention. The upper plate 601A1 includes a number of inlets 705A1 distributed in a location near a center of the upper plate 601A1. In one embodiment, the upper plate 601A1 includes a number of outlets 705B1 distributed about periphery of the upper plate 601A1 at a location near the periphery of the wafer 1171. In another embodiment, the lower plate 1091 includes a number of outlets 209A1 distributed in a substantially uniform manner around the periphery of the lower plate 1091. In yet another embodiment, the upper plate 601A1 includes the number of outlets 705B1 and the lower plate 1091 includes the number of outlets 209A1. In either embodiment, the fluid is introduced into the wafer processing volume 1191 through the number of inlets 705A1 and removed from the wafer processing volume 1191 through the number of outlets 705B1 and/or 209A1. The configuration of the number of inlets 705A1 and the number of outlets 705B1 and/or 209A1 causes the fluid to flow from a central region to a peripheral region of the wafer 1171.

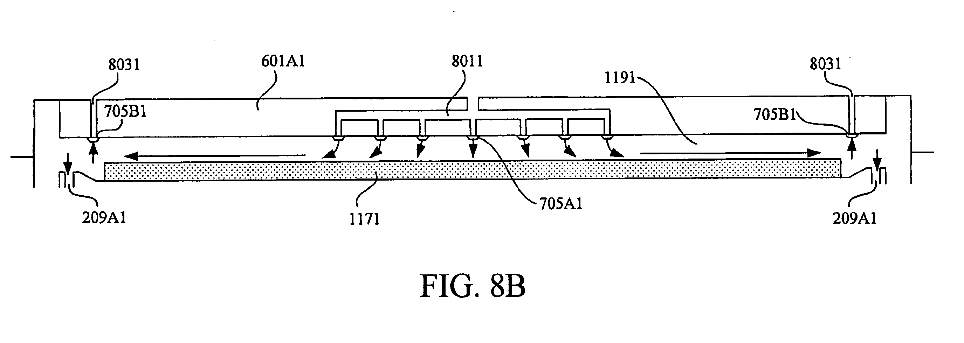

Figure 8B is an illustration showing the use of fluid channels within the upper plate 601A1, in accordance with one embodiment of the present invention. Fluid channels 8011 are provided for transferring fluid to the number of inlets 705A1. Fluid channels 8031 are provided for transferring fluid from the number of outlets 705B1. Use of fluid channels to independently control different inlets and outlets within the upper plate 601A1 allows for pressure equalization and flow pattern control within the wafer processing volume 1191. Additionally, the use of fluid channels provides flexibility in changing flow patterns within the wafer processing volume 1191 and in varying the pressure differential between the wafer processing volume 1191 and the intermediate volume 6051.

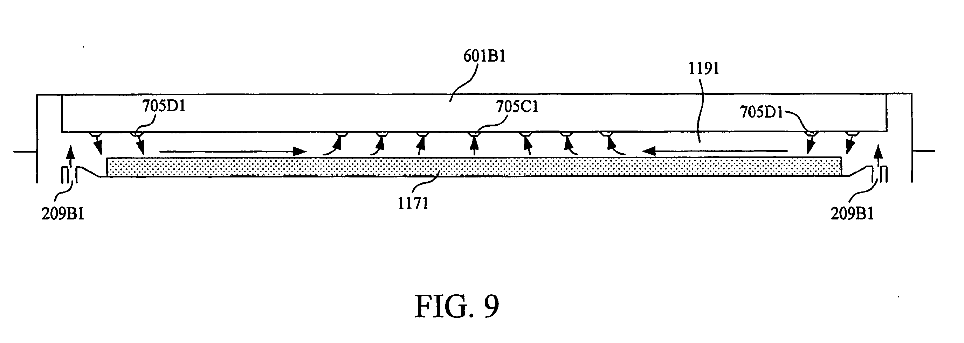

Figure 9 is an illustration shoving an upper plate 601B1 configured to provide a peripheral fluid feed and a central fluid exhaust, in accordance with one embodiment of the present invention. The upper plate 601B1 includes a number of outlets 705C1 distributed in a location near a center of the upper plate 601B1. In one embodiment, the upper plate 601B1 includes a number of inlets 705D1 distributed about periphery of the upper plate 601B1 at a location near the periphery of the wafer 1171. In another embodiment, the lower plate 1091 includes a number of inlets 209B1 distributed in a substantially uniform manner around the periphery of the lower plate 1091. In yet another embodiment, the upper plate 601B1 includes the number of inlets 705D1 and the lower plate 1091 includes the number of inlets 209B1. In either embodiment, the fluid is introduced into the wafer processing volume 1191 through the number of inlets 705D1 and/or 209B1 and removed from the wafer processing volume 1191 through the number of outlets 705C1. The configuration of the number of inlets 705D1 and/or 209B1 and the number of outlets 705C1 causes the fluid to flow from a peripheral region to a central region of the wafer 1171.

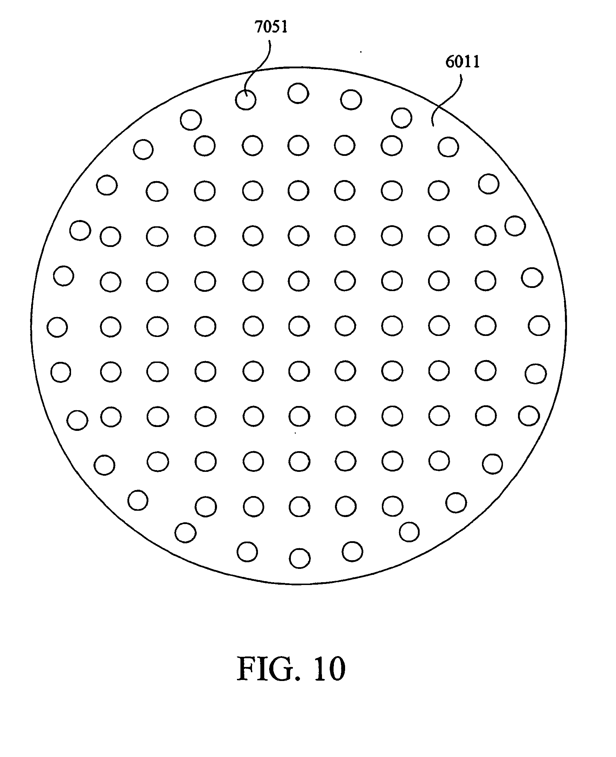

Figure 10 is an illustration showing an exemplary distribution of the inlets/outlets 7051 across the upper plate 6011, in accordance with one embodiment of the present invention. The number and distribution of inlets/outlets 7051 will depend upon the desired fluid flow pattern to be applied within the wafer processing volume 1191. The distribution of inlets/outlets 7051 as shown in Figure 10 provides an example of possible inlet/outlet 7051 locations across the upper plate 6011. Other inlet/outlet 7051 numbers and distributions can be employed to satisfy the fluid flow pattern requirements of a particular wafer processing operation.

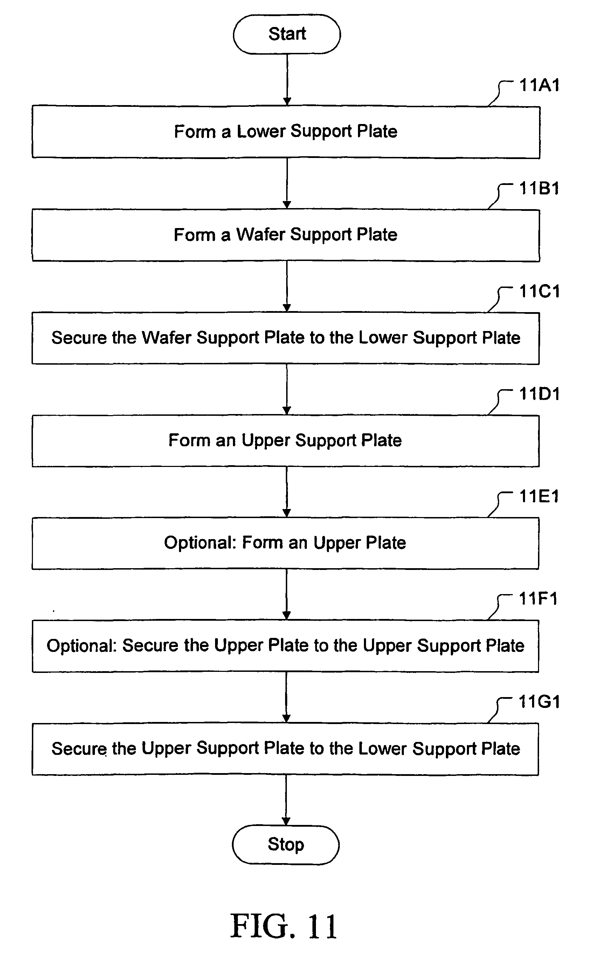

Figure 11 is an illustration showing a flowchart of a method for making a wafer processing chamber, in accordance with one embodiment of the present invention. The method includes an operation 11A1 in which a lower support plate is formed. In one embodiment, the lower support plate is formed from stainless steel. In other embodiments, the lower support plate can be formed from other materials that are compatible with the processes to be performed within the wafer processing chamber. The forming can be accomplished by pouring molten material into a mold or by machining a block of material. The lower support plate is formed to have support surfaces distributed within a first volume defined within the lower support plate. The first volume is defined to have a first fluid inlet and a first fluid outlet. The lower support plate is capable of withstanding a pressure differential to be applied between volumes located at each side of the lower support plate.

The method also includes an operation 11B1 in which a wafer support plate is formed. In one embodiment, the wafer support plate is formed from stainless steel. In other embodiments, the wafer support plate can be formed from other materials that are compatible with the processes to be performed within the wafer processing chamber. The forming can be accomplished by pouring molten material into a mold or by machining a block of material. The wafer support plate is formed to have wafer support surfaces distributed within a second volume defined within the wafer support plate. The wafer support surfaces are configured to receive a wafer. Once received, the wafer forms an upper boundary for the second volume defined within the wafer support plate. The second volume is defined to have a second fluid inlet and a second fluid outlet. Additionally, fluid inlets and fluid outlets are provided at a periphery of the wafer support plate and outside a location that is to receive the wafer. The peripheral fluid inlets and fluid outlets of the wafer support plate can be configured to create a fluid flow pattern within the third volume. In some embodiments, the fluid flow pattern can be either a linear pattern, a conical pattern, or a spiral pattern. In other embodiments, different fluid flow patterns can be created to satisfy the requirements of a wafer processing operation. The wafer support plate is capable of withstanding a pressure differential to be applied between volumes located at each side of the wafer support plate.

The method further includes an operation 11C1 in which the wafer support plate is secured to the lower support plate. Once secured, the wafer support plate is supported by the support surfaces distributed within the first volume of the lower support plate. Also, the wafer support plate serves as an upper boundary for the first volume defined within the lower support plate.

The method continues with an operation 11D1 in which an upper support plate is formed. In one embodiment, the upper support plate is formed from stainless steel, In other embodiments, the upper support plate can be formed from other materials that are compatible with the processes to be performed within the wafer processing chamber. The forming can be accomplished by pouring molten material into a mold or by machining a block of material. The upper support plate is formed to contain a third volume that is configured to overlie the wafer to be received by the wafer support surfaces of the wafer support plate. The upper support plate is capable of withstanding a pressure differential to be applied between volumes located at each side of the upper support plate.

In one embodiment, support surfaces are formed within the upper support plate. The support surfaces are distributed within a fourth volume. The fourth volume can have a fluid inlet and a fluid outlet. The support surfaces formed within the upper support plate are configured to receive and support an upper plate. In accordance with this embodiment, the method includes an optional operation 11E1, in which the upper plate is formed In one embodiment, the upper plate is formed from stainless steel. In other embodiments, the upper plate can be formed from other materials that are compatible with the processes to be performed within the wafer processing chamber. The forming can be accomplished by pouring molten material into a mold or by machining a block of material. The upper plate is formed to have fluid inlets and fluid outlets capable of introducing fluid to and removing fluid from third volume. The fluid inlets and fluid outlets of the upper plate can be configured to create a fluid flow pattern within the third volume. In some embodiments, the fluid flow pattern can be either a linear pattern, a conical pattern, a spiral pattern, a center feed with peripheral exhaust pattern, or a peripheral feed with center exhaust pattern. In other embodiments, different fluid flow patterns can be created to satisfy the requirements of a wafer processing operation. Also in accordance with this embodiment, the method includes an optional operation 11F1, in which the upper plate is secured to the support surfaces of the upper support plate. In this manner, the upper plate serves as a lower boundary to the fourth volume and an upper boundary to the third volume. The upper plate is capable of withstanding a pressure differential between the fourth volume and the third volume.

The method also includes an operation 11G1 in which the upper support plate is secured to the lower support plate. Securing the upper support plate to the lower support plate causes the third volume defined within the upper support plate to be isolated from an outside environment. Isolation of the third volume from the outside environment is enabled by a seal disposed between the upper support plate and the lower support plate.

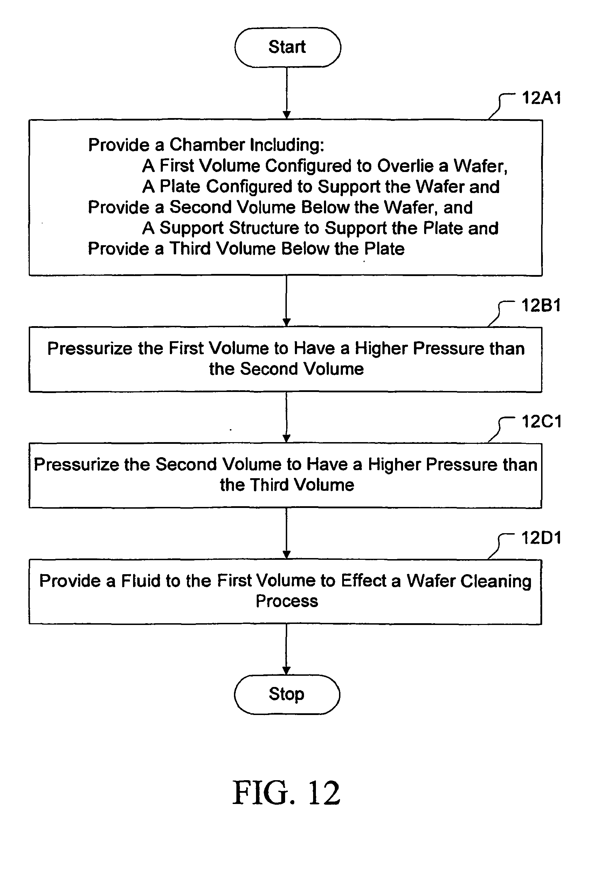

Figure 12 is an illustration showing a flowchart of a method for performing a wafer cleaning process, in accordance with one embodiment of the present invention. The method includes and operation 12A1 for providing a chamber in which the wafer cleaning process can be performed. The chamber includes a first volume configured to overlie a wafer to be cleaned. The chamber also includes a plate configured to support the wafer. A second volume is defined within the plate directly below the wafer. Also in the chamber, a support structure is provided to support the plate. The support structure includes a third volume located directly below the plate. The method further includes an operation 12B1 for pressurizing the first volume to have a higher pressure than the second volume. Also in the method, an operation 12C1 is provided for pressurizing the second volume to have a higher pressure than the third volume. The third volume is pressurized to have a pressure between that of the second volume and an environment outside the chamber. The method also includes an operation 12D1 for providing a fluid to the first volume that overlies the wafer to be cleaned. The fluid is formulated to effect the wafer cleaning process. In one embodiment, the fluid is a supercritical fluid.

The wafer processing chamber of the present invention is well suited for use in a wafer process that utilizes a supercritical fluid. As previously described, the wafer processing chamber is suited for controlling the pressure within the wafer processing volume. Additionally, the wafer processing chamber is capable of controlling the pressure differentials that exist between the wafer processing volume, the intermediate volume of the chamber, and the outside environment. Having an ability to adjust the wafer processing volume pressure relative to the chamber intermediate volume pressures, as afforded by the present invention, can be valuable in designing a supercritical fluid processing chamber that is minimal in size. Also, in supercritical fluid wafer processing, the pressure within the wafer processing volume must be controlled to maintain the supercritical state of the fluid.

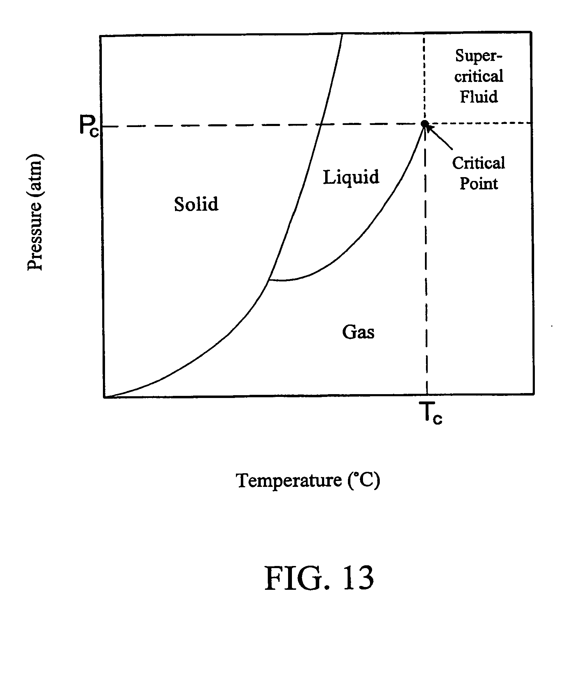

Figure 13 is an illustration showing a generalized material phase diagram. The phase of the material is represented as regions of solid, liquid, and gas, wherein the presence of a particular phase is dependent on pressure and temperature. The gas-liquid phase boundary follows an increase in both pressure and temperature up to a point called the critical point. The critical point is delineated by a critical pressure (P_{c}) and a critical temperature (T_{c}). At pressures and temperatures beyond P_{c} and T_{c}, the material becomes a supercritical fluid.

Wafer cleaning operations can be performed using the supercritical fluid. The supercritical fluid shares the properties of both a gas phase and a liquid phase. The supercritical fluid has near zero surface tension. Therefore, the supercritical fluid can reach into and between small features on the wafer surface. Also, the supercritical fluid has a diffusivity property similar to a gas. Therefore, the supercritical fluid can get into porous regions of wafer materials, such as low-K dielectric material, without becoming trapped. Additionally, the supercritical fluid has a density similar to a liquid. Therefore, more supercritical fluid can be transported to the wafer in a given amount of time as compared to a gas.

Wafer processing with the supercritical fluid must be performed at high pressures to maintain the supercritical state of the fluid. For example, supercritical fluid processing can be performed at pressures ranging from about 68 atm to about 273 atm. Therefore, the wafer processing chamber must be able to withstand the associated high pressures. The wafer processing chamber of the present invention is capable of withstanding and controlling the high pressures associated with supercritical fluids.

Generally speaking, in supercritical fluid processes, the wafer processing volume is pressurized and the temperature within the wafer processing volume is controlled. The wafer processing volume pressure and temperature are controlled to maintain a supercritical fluid state. In an exemplary embodiment, the wafer processing volume can be pre-pressurized with CO₂ only or with a mixture of CO₂ and an appropriate chemistry. The critical pressure and temperature for CO₂ is approximately 73 atm and 31°C, respectively. It should be noted that the supercritical fluid used in combination with the wafer processing chamber of the present invention is not restricted to CO₂. Other suitable supercritical fluids can also be used. Additionally, the chemistry of the supercritical fluid may include additives such as co-solvents, co-chelating agents, surfactants, or any combination thereof. The additives contained within the supercritical fluid can be useful for performing specific functions, such as dissolving and removing photoresist, dissolving and removing organic residue, and chelating metals, among others.

The advantages of the wafer processing chamber of the present invention are numerous. One advantage is that the wafer processing chamber is completely configurable. By interchanging the upper and lower plates, the chamber can be converted to several different configurations without changing the main chamber body. This advantage allows one type of chamber to be used for several potential wafer processing applications. Also, the interchangeability of the upper and lower plates allows the wafer processing volume pressure and flow pattern to be appropriately selected for a particular wafer processing application. Additionally, during a wafer cleaning process, there is a potential that material being cleaned from the wafer can become trapped in cavities within the chamber. Since the upper and lower plates are removable, both the chamber and the upper and lower plates can be more easily cleaned.

The wafer processing chamber of the present invention can be incorporated into a wafer processing cluster architecture. In one example, the wafer processing cluster architecture can incorporate separate modules for performing wafer cleaning operations, wafer etching operations, CMP operations, and wafer rinsing operations. Additionally, in the wafer processing cluster architecture, the wafer can be transferred between different modules using a robotic wafer handling mechanism or a track mechanism.

### Wafer Clamping Apparatus

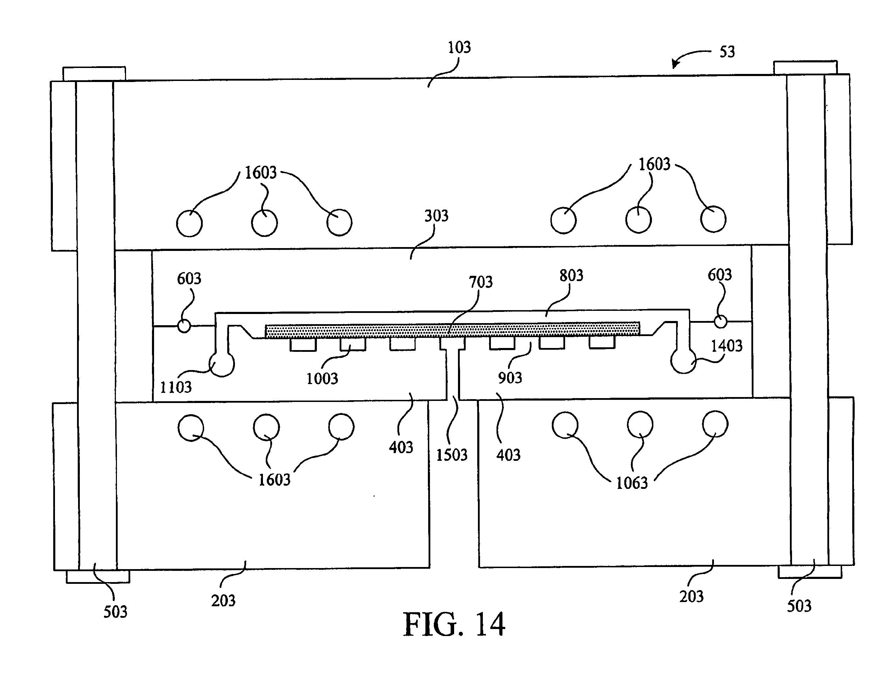

Figure 14 is an illustration showing a cross-section view of a wafer processing chamber ("chamber") 53, in accordance with one embodiment of the present invention. The chamber 53 includes a lower plate 403 which serves in part as a wafer support structure. The lower plate 403 includes a number of wafer support surfaces 903 distributed to provide substantially uniform support to a wafer 703 to be disposed within the chamber 53. The number of wafer support surfaces 903 are separated to form a lower volume 1003. The lower volume 1003 is located beneath the wafer 703 to be disposed on the lower plate 403. Hence, with respect to the wafer 703, the lower volume 1003 is also referred to as an underlying volume 1003. An outlet 1503 is provided to remove fluids from the lower volume 1003.

The chamber 53 also includes an upper plate 303 that is configured to interface with a top portion of the lower plate 403. The upper plate 303 includes an upper volume 803 defined above the wafer 703. The upper volume 803 is configured to overlie the wafer 703 when the upper plate 303 is attached to the lower plate 403. Hence, with respect to the wafer 703, the upper volume 803 is also referred to as an overlying volume 803.

A fluid for use in a wafer processing operation can be supplied to the upper volume 803 through an inlet 1103. In one embodiment, the inlet 1103 includes a fluid supply pathway disposed within the lower plate 403. In another embodiment, the fluid supply pathway of the inlet 1103 can be disposed within the upper plate 303. In either embodiment, the fluid supply pathway is in fluid communication with the upper volume 803 through a number of inlet nozzles.

The fluid for use in the wafer processing operation can be removed from the upper volume 803 through an outlet 1403. In one embodiment, the outlet 1403 includes a fluid removal pathway disposed within the lower plate 403. In another embodiment, the fluid removal pathway of the outlet 1403 can be disposed within the upper plate 303. In either embodiment, the fluid removal pathway is in fluid communication with the upper volume 803 through a number of outlet nozzles. Thus, the fluid can be supplied through the inlet 1103, flow through the upper volume 803 across a top surface of the wafer, and exit through the outlet 1403.

A seal 603 is disposed between the upper plate 303 and the lower plate 403 at a peripheral location where the upper plate 303 and the lower plate 403 are in contact. The seal 603 traverses the periphery of the upper volume 803 and serves to isolate the upper volume 803 from an outside environment. To enable the seal 603, the upper plate 303 and lower plate 403 are forced together.

An upper support plate 103 is disposed above the upper plate 303, and a lower support plate 203 is disposed below the lower plate 403. A number of bolts 503 are utilized at peripheral locations to hold the upper support plate 103 and the lower support plate 203 together. The number of bolts 503 are tightened to pull the upper support plate 103 toward the lower support plate 203. As the upper support plate 103 is pulled toward the lower support plate 203, the upper plate 303 will be forced toward the lower plate 403. This forcing of the upper plate 303 toward the lower plate 403 causes the seal 603 to be enabled. The upper support plate 103 provides backing support for the upper plate 303. Similarly, the lower support plate 203 provides backing support for the lower plate 403. Some wafer processes must be performed at extremely high pressures. Thus, the upper support plate 103, the lower support plate 203, and the bolts 503 provide sufficient strength to withstand the pressure which may exist within the upper volume 803. Additionally, some wafer processes must be performed at specific temperatures. In order to provide temperature control within the upper volume 803, across the wafer 703, and within the lower volume 1003, thermal control devices 1603 can be disposed within the upper support plate 103 and the lower support plate 203. In one embodiment, the thermal control devices 1603 can include heat exchanger fluid pathways. In another embodiment, the thermal control devices 1603 can include electric heating elements. In either embodiment, conduction through the upper plate 303 and lower plate 403 provide a transfer mechanism to move heat from the thermal control devices 1603 to the regions of interest (e.g., upper volume 803, wafer 703, or lower volume 1003).

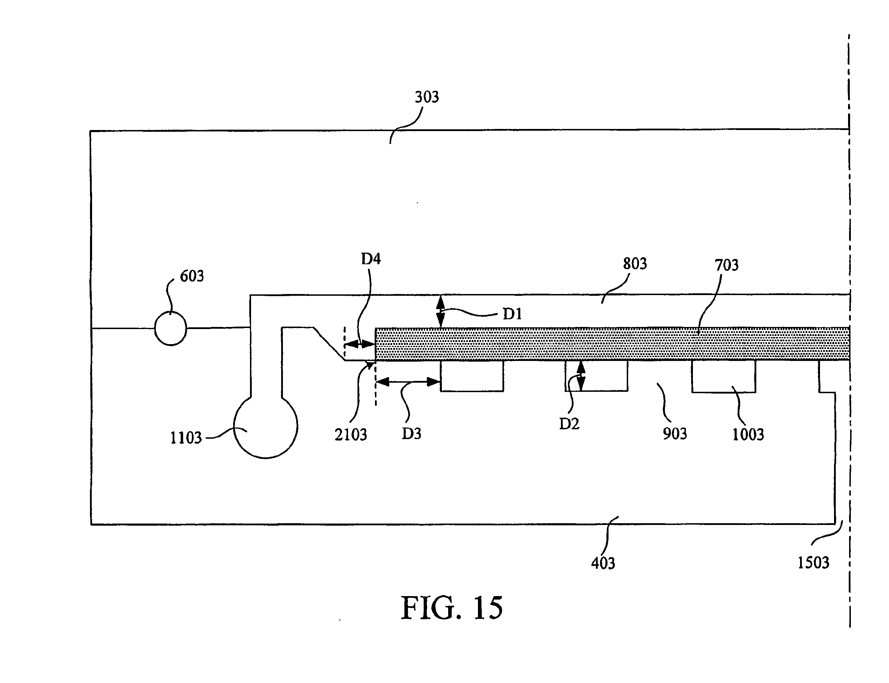

Figure 15 is an illustration showing close-up view of the interface between the upper plate 303 and the lower plate 403, in accordance with one embodiment of the present invention. The close-up view shows a vertical cross-section of the upper plate 303 and the lower plate 403 across half of the chamber. As discussed with respect to Figure 14, the lower plate 403 serves as the wafer support structure having the number of wafer support surfaces 903 upon which the wafer 703 will be secured during wafer processing. The lower volume or underlying volume 1003 is formed between the wafer support surfaces 903 and below the wafer 703. The outlet 1503 for removing fluids from the lower volume 1003 is shown disposed approximately at the center of the lower plate 403. In other embodiments, the outlet 1503 can be disposed at other locations within the lower plate 403. The inlet 1103 for supplying fluid to the upper volume 803 is also shown as being disposed within the lower plate 403.

The upper volume 803 is formed within the upper plate 303 to overlie the wafer 703 when the upper plate 303 is joined with the lower plate 403. The seal 603 is shown positioned near the periphery of the upper plate 303 and the lower plate 403, and outside the upper volume 803. The seal 603 isolates the upper volume 803 from the outside environment. Since the wafer 703 is not hermetically sealed to the lower plate 403 during wafer processing, the upper volume 803 will be in fluid communication with the lower volume 1003 through a limited fluid communication pathway 2103 at the periphery of the wafer 703. The limited fluid communication pathway 2103 is essentially the area between the wafer 703 and the peripheral wafer support surface 903 of the lower plate 403.

During operation, the pressure in the upper volume 803 will be maintained at a higher level than the pressure in the lower volume 1003, thus creating a pressure differential through the wafer 703 from top to bottom. The pressure differential serves to pull the wafer 703 toward the lower plate 403 with sufficient force to secure the wafer 703 to the wafer support surfaces 903. Since the pressure in the upper volume 803 is higher than the pressure in the lower volume 1003, some fluid will pass from the upper volume 803 through the limited fluid communication pathway 2103 to the lower volume 1003. The outlet 1503 can be used to remove fluid from the lower volume 1003 as necessary. In one embodiment, the outlet has a diameter of about 0.25 inch. However, in other embodiments, the outlet can have a different diameter. As used herein, the term "about" means within ± 10% of a specified value.

The dimensions of the upper volume 803, lower volume 1003, and wafer support surfaces 903 can vary depending upon the requirements (e.g., pressure, fluid flow rate, fluid composition, etc...) of the wafer process to be performed. In one embodiment, a separation distance D1 between the upper plate 303 and the wafer 703 top surface is about 1 mm (0.04 inch). However, in other embodiments different values for D1 may be used. In one embodiment, a depth D2 of the lower volume 1003 between the wafer 703 and the lower plate 403 can be within a range extending from about 0,13 mm (0.005 inch) to about 1 mm (0.04 inch). In particular embodiment, the depth D2 is about 0,5 mm (0.02 inch). In one embodiment, an overlap distance D3 between the wafer 703 and the peripheral wafer support surface 903 can be within a range extending from about 2,5 mm (0.1 inch) to about 12,7 mm(0.5 inch). In a particular embodiment, the overlap distance D3 is about 6,35 mm (0.25 inch). The overlap distance D3 is a key factor in establishing the pressure drop between the upper volume 803 and the lower volume 1003, through the limited fluid communication pathway 2103. In one embodiment, a wafer positioning tolerance D4 (i.e., nominal distance between the wafer 703 edge and a wafer pocket perimeter within the lower plate 403) can be within a range extending from about 0,64 mm (0.025 inch) to about 2,5 mm (0.1 inch). The wafer positioning tolerance D4 may be dictated by a precision of a robotic wafer handling device.

The wafer support surfaces 903 are configured to contact a percentage of the wafer 703 commensurate with the pressure differential to be applied through the wafer 703. A higher pressure differential requires a higher percentage of the wafer 703 to be in contact with the wafer support surfaces 903. In one embodiment, the wafer support surfaces 903 can be in contact with a percentage of the wafer 703 surface within a range extending from about 5% to about 80%. In another embodiment, the wafer support surfaces 903 can be in contact with a percentage of the wafer 703 surface within a range extending from about 15% to about 25%. In yet another embodiment, the wafer support surfaces 903 can be in contact with about 20% of the wafer 703 surface. With a differential pressure within a range extending from about 1 atm to about 1.5 atm, the wafer support surfaces 903 can be in contact with a percentage of the wafer 703 surface within a range extending up to about 10%. With a differential pressure within a range extending from about 3 atm to about 4 atm, the wafer support surfaces 903 can be in contact with a percentage of the wafer 703 surface within a range extending from about 50% to about 70%.

It is preferable to minimize the percentage of the wafer in contact with the wafer support surfaces 903 (i.e., wafer backside contact area). Minimization of the wafer backside contact area, however, should be performed in a manner that provides sufficient support for the particular pressure differential to be applied between the volume above the wafer and the volume below the wafer. Minimizing the wafer backside contact area serves to reduce the potential for wafer contamination. Also, minimizing the wafer backside contact area reduces the potential for particles becoming lodged between the wafer and the wafer support surfaces 903, which could cause difficulty in clamping the wafer.

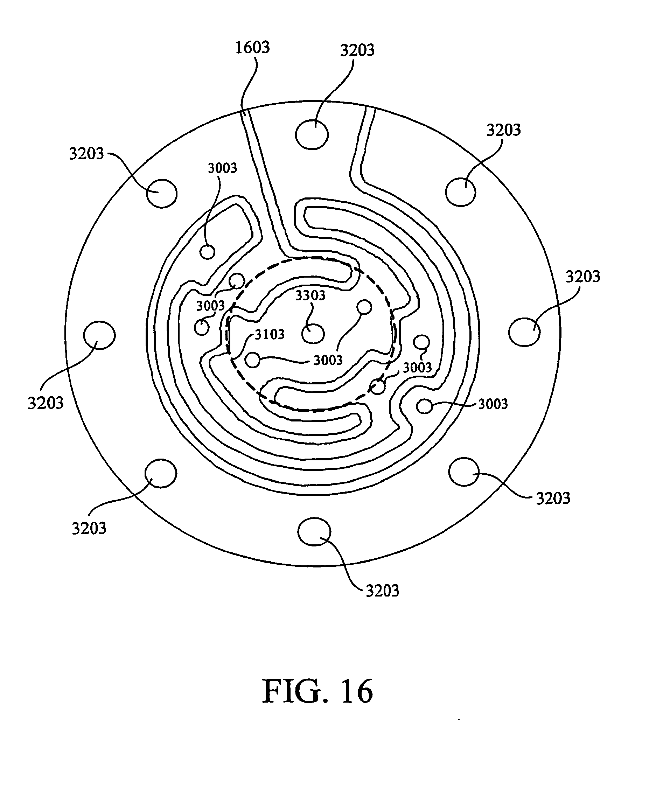

Figure 16 is an illustration showing a plan view of the lower support plate 203, in accordance with one embodiment of the present invention. As previously discussed, the lower support plate 203 includes a number of holes 3203 through which bolts 503 are passed to secure the lower support plate 203 to the upper support plate 103. The lower support plate 203 also includes the thermal control device 1603. In the embodiment of Figure 16, the thermal control device 1603 is depicted as a heat exchanger fluid pathway configured to substantially traverse a region of the lower support plate 203 to be in contact with the lower plate 403. The thermal control device 1603 of Figure 16 is shown for exemplary purposes only. In other embodiments, the thermal control device 1603 can be configured differently and/or incorporate alternate components such as electric heating elements. For illustrative purposes, the area over which the wafer 703 will be disposed is depicted by a line 3103. An access port 3303 is provided within the lower support plate 203 to allow access to the outlet 1503 for removing fluid from the lower volume 1003. Additionally, a number of access ports 3003 are provided within the lower support plate 203. Some of the number of access ports 3003 can be configured to access different regions such as the upper volume 803 or the lower volume 1003. The number of access ports 3003 can be used to insert pressure monitoring devices, temperature monitoring devices, viewing devices, or any combination thereof.

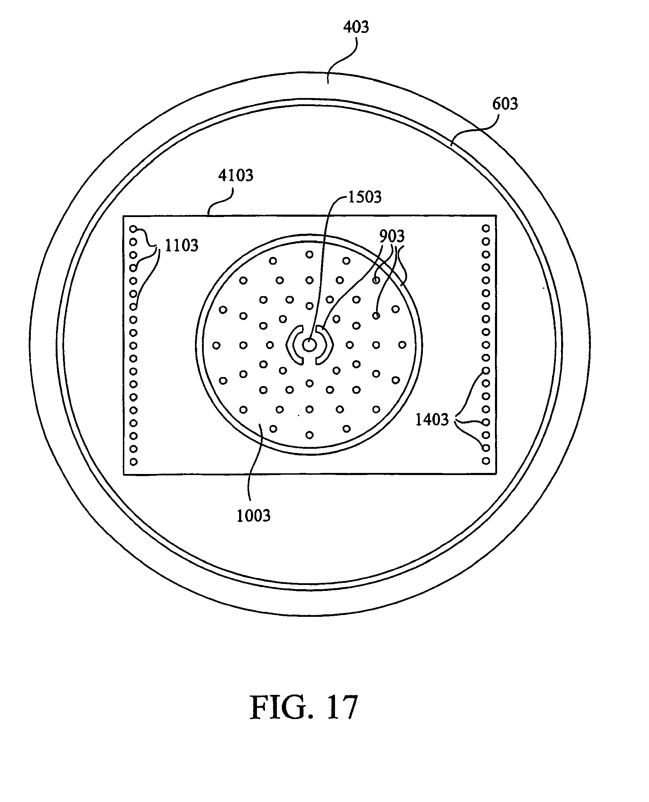

Figure 17 is an illustration showing a plan view of the lower plate 403, in accordance with one embodiment of the present invention. The seal 603 is shown traversing the periphery of the lower plate 403. Toward the center of the lower plate 403, the number of wafer support surfaces 903 are shown. The number of wafer support surfaces 903 are distributed to contact the wafer 703 in a substantially uniform manner, thus providing substantially uniform resistance to the force transmitted through the wafer by the pressure differential that exists between the upper volume 803 and the lower volume 1003. The lower volume 1003 occupies the space between the wafer support surfaces 903 below the wafer 703.

The number of inlet nozzles referred to in the description of Figure 14 are shown as items 1103 in Figure 17. Also, the number of outlet nozzles referred to in the description of Figure 14 are shown as items 1403 in Figure 17. Fluid used to perform the wafer processing enters through the inlet nozzles 1103 into the upper volume 803 and exits through the outlet nozzles 1403. In this manner, the fluid flows from the inlet nozzles 1103 to the outlet nozzles 1403 across the top surface of the wafer 703. Hence, the fluid generally flows within a region 4103. However, a small amount of fluid may enter between the region 4103 and the seal 603. In one embodiment, a number of weep holes are provided for removal of the fluid that enters between the region 4103 and the seal 603.

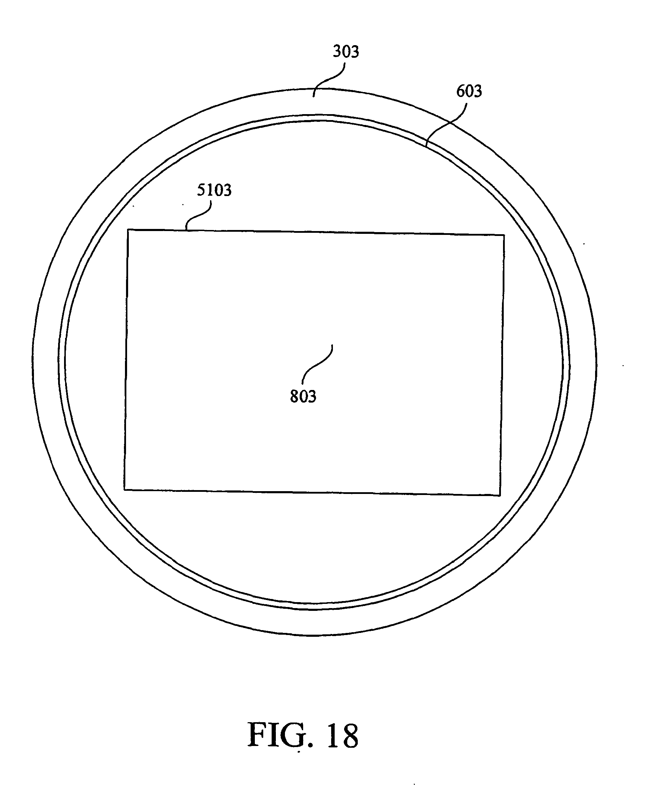

Figure 18 is an illustration showing a plan view of the upper plate 303, in accordance with one embodiment of the present invention. The seal 603 is shown traversing the periphery of the upper plate 303. A boundary 5103 is shown to depict a perimeter of the upper volume 803. The boundary 5103 coincides substantially with the region 4103, depicted in Figure 17. In other embodiments, the boundary 5103 and the region 4103 may be defined by different shapes.

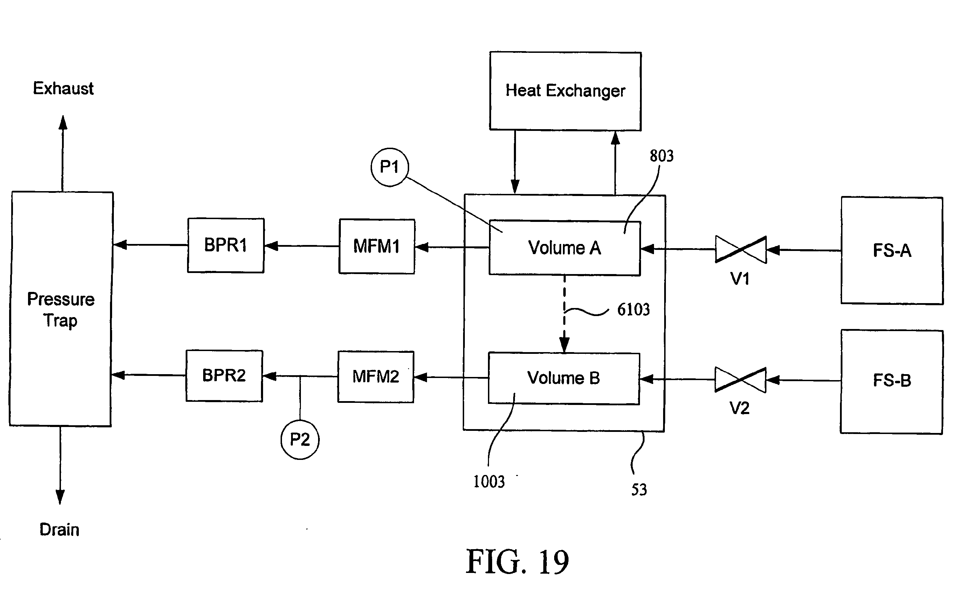

Figure 19 is an illustration showing a fluid flow system associated with the wafer clamping apparatus, in accordance with one embodiment of the present invention. The wafer processing chamber 53 is depicted as having a Volume A and a Volume B. With respect to the wafer processing chamber 53 as previously described, Volume A corresponds to the upper volume 803 located above the wafer 703, and Volume B corresponds to the lower volume 1003 located below the wafer 703 and between the wafer support surfaces 903. Volume A is shown to be in limited fluid communication with Volume B by a dashed arrow 6103. The limited fluid communication corresponds to the wafer 703 not being hermetically sealed to the lower plate 403, as discussed with respect to Figure 15. The wafer processing chamber 53 is also shown to have a heat exchanger to provide thermal control within Volume A and Volume B. In other embodiments, different thermal control devices can be incorporated.

The fluid for use in the wafer processing is provided from a fluid source FS-A through a valve V1 to Volume A. The fluid flows through Volume A, through a mass flow meter MFM1, through a back pressure regulator BPR1, to a pressure trap. The mass flow meter MFM1 is used to monitor the fluid flow rate through Volume A. The back pressure regulator BPR1 is used to control the pressure in Volume A. A pressure monitor P1 is also provided for monitoring the pressure in Volume A. The pressure monitor P1 does not have to be located directly over the wafer. However, the pressure monitor P1 should be disposed within Volume A. The pressure trap is equipped with an exhaust and a drain. The pressure trap is used to maintain a minimum pressure within the fluid flow system.

Some fluid will enter Volume B from Volume A through the limited fluid communication indicated by the arrow 6103. The fluid in Volume B flows through Volume B, through a mass flow meter MFM2, through a back pressure regulator BPR2, to the pressure trap. The mass flow meter MFM2 is used to monitor the fluid flow rate through Volume B. An abnormally high fluid flow rate indication by MFM2 could relate to improper seating of the wafer 703 on the wafer support surfaces 903 of the lower plate 403. An improper seating of the wafer 703 is a condition that would require remedy prior to commencement of wafer processing operations. Otherwise, the wafer could potentially lift and become mobile. The back pressure regulator BPR2 is used to control the pressure in Volume B. A pressure monitor P2 is also provided for monitoring the pressure in Volume B. The pressure monitor P2 does not have to be located directly below the wafer. However, the pressure monitor P2 should be disposed along a fluid pathway connected to Volume B.

In one embodiment, the only fluid that enters Volume B is the fluid that traverses the limited fluid communication indicated by the arrow 6103. In another embodiment, additional fluid can be supplied to Volume B. The additional fluid is provided from a fluid source FS-B through a valve V2 to Volume B. The additional fluid source FS-B can be used to actively control the pressure within Volume B.

During operation, the pressure within Volume A and Volume B are monitored by pressure monitors P1 and P2, respectively. The difference between the pressures indicated by pressure monitors P1 and P2 represents a differential pressure acting through the wafer from top to bottom. A particular wafer processing operation may require a particular force to secure the wafer to the wafer support surfaces 903 of the lower plate 403. The differential pressure determined from P1 and P2 can be used to monitor the force being used to the secure the wafer. The back pressure regulators BPR1 and BPR 2 can be used to control the pressures in Volume A and Volume B, respectively, thus maintaining a desired differential pressure. The desired differential pressure can depend on several wafer processing parameters such as fluid flow rate across the wafer, percentage of the wafer surface contacting wafer support surfaces 903, and wafer thickness, among others. For example, the differential pressure can be maintained within a range extending from about 1 atm to about 10 atm in one embodiment. In another exemplary embodiment, the differential pressure can be maintained at about 2 atm.

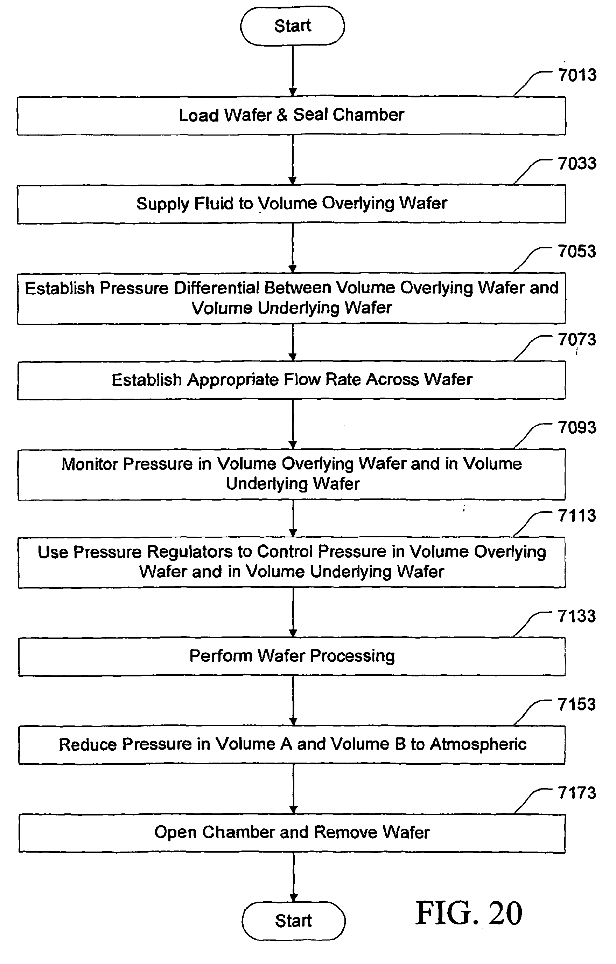

Figure 20 is an illustration showing a flowchart of a method for clamping a wafer using active and independent pressure control both above and below the wafer, in accordance with one embodiment of the present invention. The method starts with an operation 7013 in which the wafer is loaded into a chamber and the chamber is sealed. In an operation 7033, a fluid is supplied to a volume overlying the wafer within the chamber. The fluid is formulated to effect a wafer processing operation. In an operation 7053, a pressure differential is established between the volume overlying the wafer and a volume underlying the wafer. The pressure differential serves to pull the wafer down toward a wafer support structure within the chamber. The method continues with an operation 7073 in which an appropriate fluid flow rate is established across a top surface of the wafer. The appropriate fluid flow rate is determined based on requirements of the wafer processing operation to be performed. In an operation 7093, both a pressure in the volume overlying the wafer and a pressure in the volume underlying the wafer are monitored. In an operation 7113, pressure regulators are used to actively and independently control each of the pressure in the volume overlying the wafer and the pressure in the volume underlying the wafer. The pressure regulators allow a target pressure differential to be maintained between the volume overlying the wafer and the volume underlying the wafer. The target pressure differential causes the wafer to be pulled toward the wafer support structure with a specific amount of force. The force causes the wafer to be secured, thus remaining immobile during the wafer processing operation. In an operation 7133, the wafer processing is performed. Upon completion of the wafer processing, an operation 7153 is performed in which the pressures in both the volume overlying the wafer and the volume underlying the wafer are reduced to atmospheric pressure. The method concludes with an operation 7173 in which the chamber is opened and the wafer is removed.

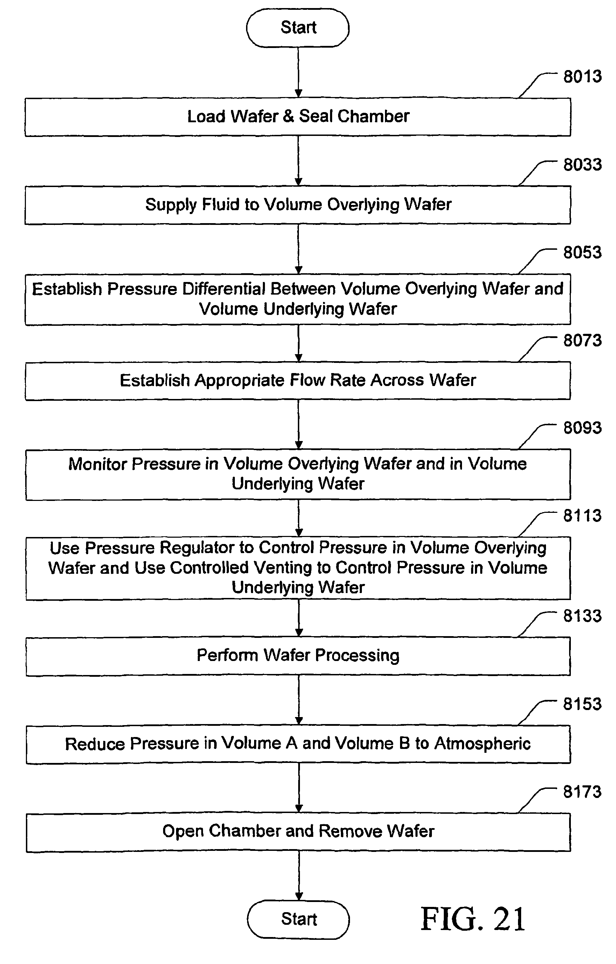

Figure 21 is an illustration showing a flowchart of a method for clamping a wafer using active pressure control above the wafer and controlled venting below the wafer, in accordance with one embodiment of the present invention. The method starts with an operation 8013 in which the wafer is loaded into a chamber and the chamber is sealed. In an operation 8033, a fluid is supplied to a volume overlying the wafer within the chamber. The fluid is formulated to effect a wafer processing operation. In an operation 8053, a pressure differential is established between the volume overlying the wafer and a volume underlying the wafer. The pressure differential serves to pull the wafer down toward a wafer support structure within the chamber. The method continues with an operation 8073 in which an appropriate fluid flow rate is established across a top surface of the wafer. The appropriate fluid flow rate is determined based on requirements of the wafer processing operation to be performed. In an operation 8093, both a pressure in the volume overlying the wafer and a pressure in the volume underlying the wafer are monitored. In an operation 8113, a pressure regulator is used to control the pressure in the volume overlying the wafer. Also, in the operation 8113, the volume underlying the wafer is vented in a controlled manner. Use of the pressure regulator in combination with the controlled venting allows a target pressure differential to be maintained between the volume overlying the wafer and the volume underlying the wafer. The target pressure differential causes the wafer to be pulled toward the wafer support structure with a specific amount of force. The force causes the wafer to be secured, thus remaining immobile during the wafer processing operation. In an operation 8133, the wafer processing is performed. Upon completion of the wafer processing, an operation 8153 is performed in which the pressures in both the volume overlying the wafer and the volume underlying the wafer are reduced to atmospheric pressure. The method concludes with an operation 8173 in which the chamber is opened and the wafer is removed.

The wafer clamping apparatus of the present invention is well suited for use in a wafer process that utilizes a supercritical fluid. As previously described, the wafer clamping apparatus is enabled by controlling a pressure differential between a top surface and a bottom surface of the wafer. The pressure differential serves to pull the wafer toward a wafer support structure in contact with the wafer bottom surface, whereby the wafer is secured and maintained in an immobile state. In supercritical fluid wafer processing, the pressure must also be controlled within the vicinity of the wafer to maintain the supercritical state of the fluid.

### High-Pressure Chamber Configuration

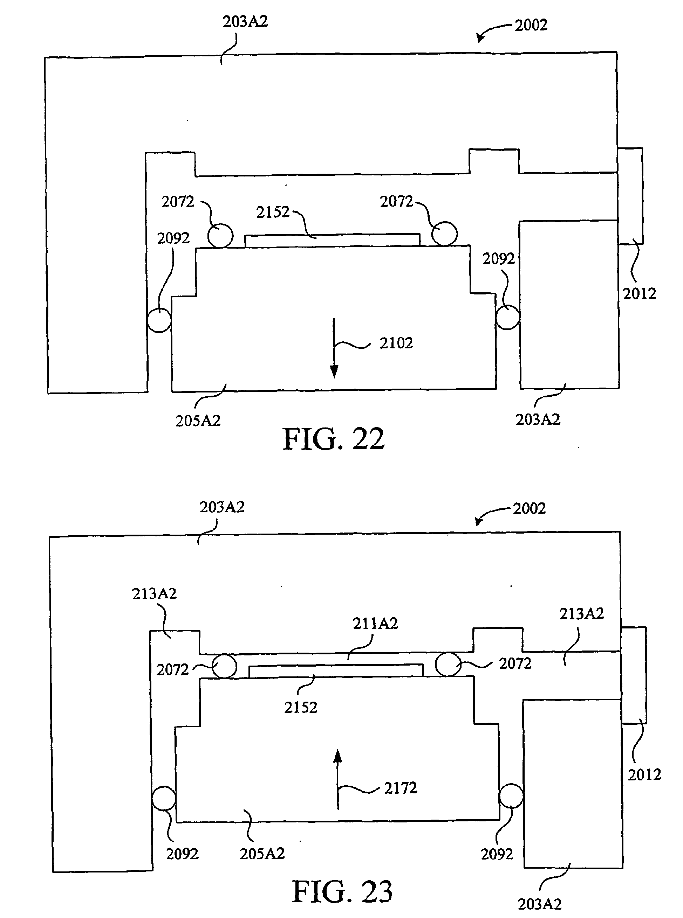

Figure 22 is an illustration showing a wafer processing chamber ("chamber") 2002 in an open state, in accordance with one embodiment of the present invention. The chamber 2002 includes an upper section 203A2 and a lower section 205A2. The upper section 203A2 is secured in an immobile condition. The immobile condition refers to the upper section 203A2 remaining stationary with respect to surrounding components including the lower section 205A2. The lower section 205A2 is configured to be moved up and down with respect to the upper section 203A2. The movement of the lower section 205A2 can be controlled by a number of mechanisms. For example, in one embodiment, the movement of the lower section 205A2 is controlled by a screw drive. In another embodiment, the movement of the lower section 205A2 is controlled by a hydraulic drive. In Figure 22, the lower section 205A2 is moved down as indicated by an arrow 2102. The chamber 2002 is configured to interface with a valve 2012. In one embodiment, the valve 2012 is either a slit valve or a gate valve. However, other embodiments can use a different type of valve 2012. When the valve 2012 is opened, a wafer 2152 can be transferred into or out of the chamber 2002. In one embodiment, the wafer 2152 can be placed on lifting pins within the chamber 2002. The lifting pins can be used to position the wafer vertically within the chamber 2002 as needed. The valve 2012 also serves to isolate volumes located on each side of the valve 2012 from one another. The chamber 2002 further includes a seal 2072 for isolating volumes within the chamber 2002 from one another. The seal 2072 is configured to enclose a periphery of the wafer 2152 to be processed within the chamber. A seal 2092 is also provided to isolate a volume within the chamber from an outside environment. In one embodiment, the outside environment is contained within a wafer transfer module. In another embodiment, the outside environment is contained within a clean room.

Figure 23 is an illustration showing the chamber 2002 in a closed state, in accordance with one embodiment of the present invention. The chamber 2002 includes the upper section 203A2, the lower section 205A2, the valve 2012, the seal 2072, and the seal 2092 as previously described with respect to Figure 22. However, the lower section 205A2 is shown to be moved up as indicated by an arrow 2172. When the lower section 205 is moved up, the seal 2072 engages the upper section 203A2. The seal 2072 can be a c-seal, an o-ring, a flat gasket, or a similar sealing mechanism. Also, the seal 2072 can be formed by multiple seals. A sufficient upward force is applied to the lower section 205A2 to enable the seal 2072. Once enabled, the seal 2072 serves to isolate a wafer processing volume 211A2 from an outer volume 213A2. All wafer processing is performed in the wafer processing volume 211A2. Fluid inlets and fluid outlets can be disposed within the upper section 203A2 and/or the lower section 205A2 for introducing fluid into and removing fluid from each of the wafer processing volume 211A2 and the outer volume 213A2. The seal 2092 serves to isolate the outer volume 213A2 from the outside environment. The seal 2092 can be an o-ring or a similar sealing mechanism. Also, the seal 2092 can be formed by multiple seals. The valve 2012 serves to isolate the outer volume 213A2. In one embodiment, the valve 2012 isolates the outer volume 213A2 from a wafer transfer module. In other embodiments, the valve 2012 is capable of isolating the outer volume 213A2 from other environments outside the chamber 2002, such as a clean room.

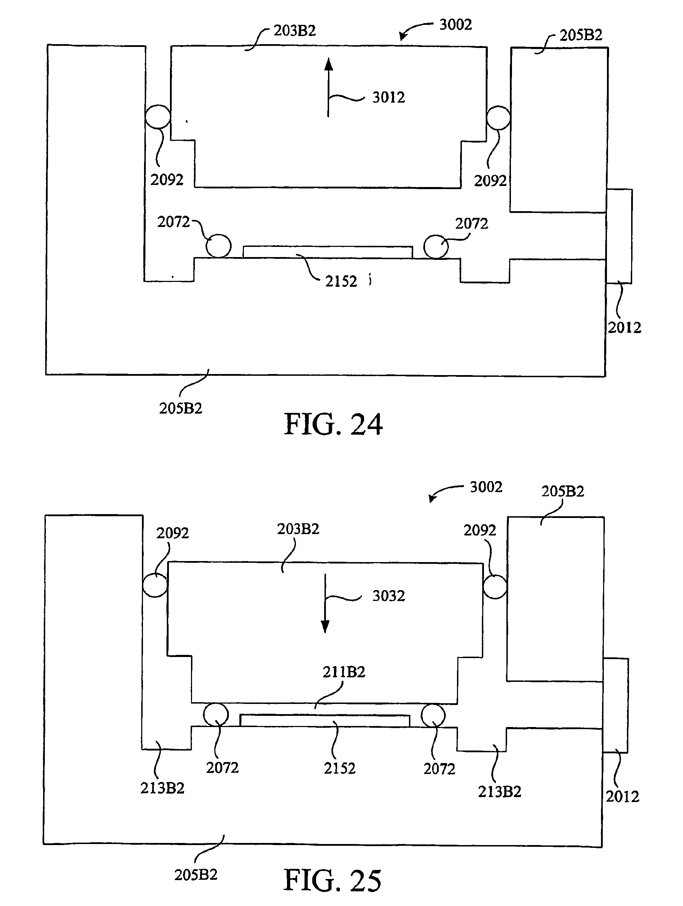

Figure 24 is an illustration showing a wafer processing chamber ("chamber") 3002 in an open state, in accordance with one embodiment of the present invention. The chamber 3002 includes an upper section 203B2 and a lower section 205B2. The lower section 205B2 is secured in an immobile condition. The immobile condition refers to the lower section 205B2 remaining stationary with respect to surrounding components including the upper section 203B2. The upper section 203B2 is configured to be moved up and down with respect to the lower section 205B2. The movement of the upper section 203B2 can be controlled by a number of mechanisms. For example, in one embodiment, the movement of the upper section 203B2 is controlled by a screw drive. In another embodiment, the movement of the upper section 203B2 is controlled by a hydraulic drive. In Figure 24, the upper section 203B2 is moved up as indicated by an arrow 3012. As with the chamber 2002, the chamber 3002 is also configured to interface with the valve 2012 through which the wafer 2152 can be transferred. In one embodiment, the wafer 2152 can be placed on lifting pins within the chamber 3002. The lifting pins can be used to position the wafer vertically within the chamber 3002 as needed. The chamber 3002 also includes the seal 2072 for isolating volumes within the chamber 3002 from one another. As previously described, the seal 2072 is configured to enclose a periphery of the wafer 2152 to be processed within the chamber 3002. The seal 2092 is also provided to isolate a volume within the chamber from the outside environment.

Figure 25 is an illustration showing the chamber 3002 in a closed state, in accordance with one embodiment of the present invention. The chamber 3002 includes the upper section 203B2, the lower section 205B2, the valve 2012, the seal 2072, and the seal 2092 as previously described with respect to Figure 24. However, the upper section 203B2 is shown to be moved down as indicated by an arrow 3032. When the upper section 203B2 is moved down, the seal 2072 engages the upper section 203B2. A sufficient downward force is applied to the upper section 203B2 to enable the seal 2072. Once enabled, the seal 2072 serves to isolate a wafer processing volume 211B2 from an outer volume 213B2. All wafer processing is performed in the wafer processing volume 211B2. Fluid inlets and fluid outlets can be disposed within the upper section 203B2 and/or the lower section 205B2 for introducing fluid into and removing fluid from each of the wafer processing volume 211B2 and the outer volume 213B2. The seal 2092 serves to isolate the outer volume 213B2 from the outside environment. Also, the valve 2012 serves to isolate the outer volume 213B2. In one embodiment, the valve 2012 isolates the outer volume 213B2 from a wafer transfer module. In other embodiments, the valve 2012 is capable of isolating the outer volume 213B2 from other environments outside the chamber 3002, such as a clean room.

The wafer processing volumes 211A2 and 211B2 are smaller that the outer volumes 213A2 and 213B2, respectively. The wafer processing volumes 211A2 and 211B2 are defined to have a minimal size in order to minimize a force necessary to constrain pressures within the wafer processing volumes 211A2 and 211B2. At higher pressures, more force is required to maintain the seal 2072 between the wafer processing volumes 211A2 and 211B2 and the outer volumes 213A2 and 213B2, respectively. One advantage of having separate wafer processing volumes 211A2 and 211B2, is that they can be configured to have a minimal size to withstand higher pressures. The wafer processing volumes 211A2 and 211B2 and the seal 2072 can be configured to contain high pressures within a range extending from about 68 atm (about 1000 psig) to about 273 atm (about 4000 psig). As used herein, the term "about" means within ± 10% of a specified value.

The chamber outer volumes 213A2 and 213B2 serve as a buffer between the wafer processing volumes 211A2 and 211B2, respectively, and the environment outside the chamber. Serving as the buffer, the outer volumes 213A2 and 213B2 can be used to transition from a high pressure contained within the wafer processing volumes 211A2 and 211B2, respectively, to a lower pressure in the environment outside the chamber. In this manner, a differential pressure between the wafer processing volumes 211A2 and 211B2 and the environment outside the chamber can be controlled. In one embodiment where the valve 2012 is used to separate the outer volumes 213A2 and 213B2 from the environment outside the chamber, the outer volumes 213A2 and 213B2 can contain a pressure within a range extending from about 6E-5 atm (about 50 mTorr) to about 1.02 atm (about 15 psig).

Incorporation of an inner wafer processing volume that is separate from an outer volume within the chamber allows the chamber to be adaptable to both an atmospheric and a vacuum wafer transfer module. The outer chamber volume can be maintained at a nominal pressure, including a sub-atmospheric pressure, in order to prevent free transfer of material between the environment outside the chamber (i.e., within the wafer transfer module) and the wafer processing volume, or vice-versa. When using the chamber in connection with a wafer transfer module under a vacuum condition, the chamber outer volume can be maintained at a sub-atmospheric pressure to reduce the pressure differential between the wafer processing volume and the wafer transfer module. Maintaining the chamber outer volume at the sub-atmospheric pressure also reduces the potential for material to flow directly from the wafer processing volume to the wafer transfer module. When using the chamber in connection with a wafer transfer module under atmospheric pressure, the chamber outer volume can be maintained at a pressure greater than atmospheric to protect the wafer processing volume from potential contaminants contained within the atmosphere of the wafer transfer module.

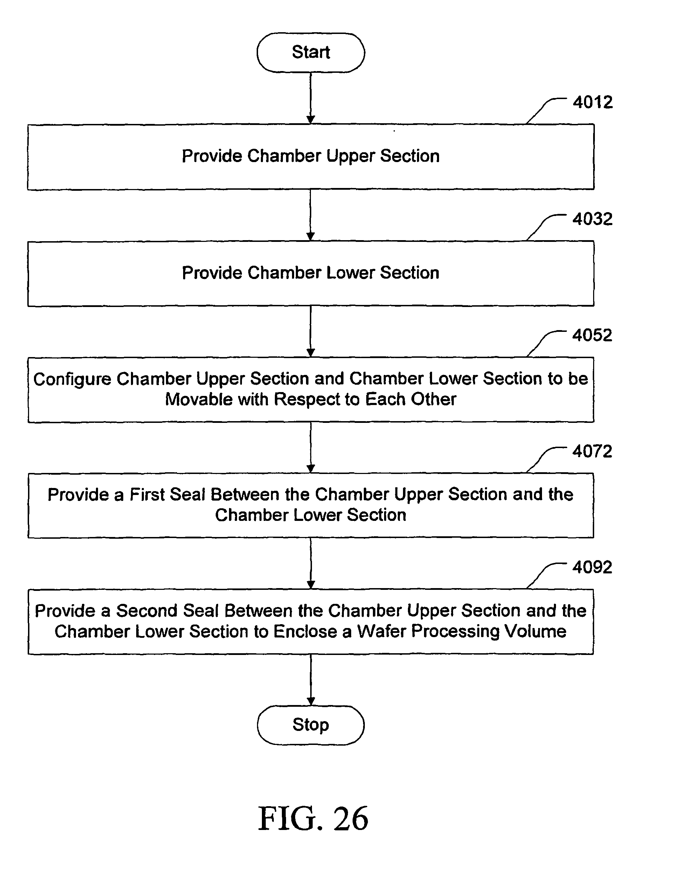

Figure 26 is an illustration showing a flowchart of a method for making a wafer processing chamber, in accordance with one embodiment of the present invention. The method includes an operation 4012 in which a chamber upper section is provided. The method also includes an operation 4032 in which a chamber lower section is provided. In an operation 4052, the chamber upper section and the chamber lower section are configured to be movable with respect to each other. The method further includes an operation 4072 in which a first seal is provided between the chamber upper section and the chamber lower section. The first seal serves to isolate a chamber outer volume from an outside environment. Additionally in the method, an operation 4092 is performed in which a second seal is provided between the chamber upper section and the chamber lower section. The second seal is configured to enclose a periphery of the wafer processing volume. Also, the second seal serves to isolate the wafer processing volume from the chamber outer volume. In one embodiment, the chamber upper section, the chamber lower section, and the second seal are configured to withstand a pressure within the wafer processing volume within a range extending from about 68 atm (about 1000 psig) to about 273 atm (about 4000 psig).

The second seal is enabled through contact with both the chamber upper section and the chamber lower section. In one embodiment, the chamber upper section is secured in a fixed position and the chamber lower section is connected to a movement mechanism. In this embodiment, the contact between the second seal and both the chamber upper section and the chamber lower section is created by operating the movement mechanism to cause the chamber lower section to move toward and contact the chamber upper section. In another embodiment, the chamber lower section is secured in a fixed position and the chamber upper section is connected to a movement mechanism. In this embodiment, the contact between the second seal and both the chamber upper section and the chamber lower section is created by operating the movement mechanism to cause the chamber upper section to move toward and contact the chamber lower section.

The wafer processing chamber of the present invention is well suited for use in a wafer process that utilizes a supercritical fluid. As previously described, the wafer processing chamber is suited for providing a high pressure within the wafer processing volume. Additionally, the wafer processing chamber is capable of controlling the pressure differentials that exist between the wafer processing volume, the chamber outer volume, and the environment outside the chamber. Having an ability to adjust the wafer processing volume pressure relative to the chamber outer volume pressure, as afforded by the present invention, is valuable in designing a supercritical fluid processing chamber that can be interfaced with a conventional wafer transfer module utilizing conventional slit valves or gate valves. Also, having an ability to maintain a high pressure within the wafer processing volume, as afforded by the present invention, is important for maintaining a supercritical fluid in a supercritical state for wafer processing.

## Claims

1. A wafer processing chamber, comprising:
a lower support (1011) having a number of support surfaces (1021), the lower support (1011) containing a first volume (1131) dispersed between the number of support surfaces (1021);
a plate (1091) supported by the number of support surfaces (1021) of the lower support (1011), the plate (1091) overlying the first volume (1131), the plate (1091) having a number of wafer support surfaces (1101) to receive and support a wafer (1171), the plate (1091) having a second volume (1151) dispersed between the number of wafer support surfaces (1101), the plate (1091) having inlets (2091) and outlets (2091) for introducing a fluid flow, the inlets (2091) and outlets (2091) being defined in a periphery of the plate (1091) and outside a location that is to receive the wafer (1171); and
an upper support (1031) overlying the plate (1091), the upper support (1031) interfacing with the lower support (1011) outside a periphery of the plate (1091), the upper support (1031) having a third volume (1191) configured to overlie the wafer (1171) to be supported by the plate (1091),
**characterized in that** the inlets (2091) and the outlets (2091) of the plate (1091) are oriented to direct a fluid flow through the third volume (1191) in a set configuration when the upper support (1031) is interfaced with the lower support (1011) outside the periphery of the plate (1091).

2. A wafer processing chamber as recited in claim 1, wherein the first volume (1131) represents an intermediate volume located between a center region and an outer region of the wafer cleaning chamber (1001), the second volume (1151) represents an underlying volume with respect to the wafer (1171), and the third volume (1191) represents an overlying volume with respect to the wafer (1171).

3. A wafer processing chamber as recited in claim 1, further comprising:
a first volume inlet (2011) for providing a fluid to the first volume (1131);
a first volume outlet (2031) for removing the fluid from the first volume (1131);
a second volume inlet (2071) for providing a fluid to the second volume (1151); and
a second volume outlet (2051) for removing the fluid from the second volume (1151).

4. A wafer processing chamber as recited in claim 1, further comprising:
a seal (1071) disposed between the upper support (1031) and the lower support (1011), the seal (1071) serving to isolate the third volume (1191) from an outside environment.

5. A method for performing a wafer cleaning process, comprising:
providing a chamber (12A1), including,
- a first volume (1191) configured to overlie a wafer;
- a plate (1091) configured to support a wafer, the plate (1091) further configured to define a second volume (1151) directly below the wafer when the wafer is supported on the plate (1091), the plate (1091) including fluid inlets (209B1) and fluid outlets (209A1) defined in a periphery of the plate and outside a portion of the plate defined to support the wafer, the fluid inlets (209B1) and fluid outlets (209A1) oriented to direct a fluid flow through the first volume (1191) in a set pattern;
- a support structure configured to support the plate, the support structure further configured to define a third volume (1131) directly below the plate (1091);
placing a wafer on the portion of the plate (1091) defined to support the wafer;
**characterized in that** the method further comprises
pressurizing (12B, 12C1) the first volume (1191), the second volume (1151), and the third volume (1131), the pressurizing causing the first volume to have a higher pressure than the second volume (1151), the pressurizing further causing the second volume (1151) to have a higher pressure than the third volume (1131); and
providing (12D1) a fluid to the first volume (1191) through the fluid inlets and removing the fluid from the first volume (1191) through the fluid outlets, the fluid being formulated to effect a wafer cleaning process.

6. A method for performing a wafer cleaning process as recited in claim 5, wherein the fluid is a supercritical fluid.

7. A method for performing a wafer cleaning process as recited in claim 5, wherein the chamber is provided as part of a wafer processing cluster architecture.

8. A method for performing a wafer cleaning process as recited in claim 5, wherein a higher pressure of the first volume (1191) relative to a pressure of the second volume (1151) serves to hold the wafer on the plate.

9. A method for performing a wafer cleaning process as recited in claim 5, wherein the set pattern of the fluid flow through the first volume (1191) is one of a linear flow pattern, a conical flow pattern, and a spiral flow pattern.

10. A method for performing a wafer cleaning process as recited in claim 5, wherein the plate includes a number of support surfaces upon which the wafer is supported, and wherein the second volume (1151) exists between the number of support surfaces of the plate and below the wafer when the wafer is supported on the plate.

11. A method for performing a wafer cleaning process as recited in claim 10, wherein the number of support surfaces are distributed in a substantially uniform manner across the portion of the plate defined to support the wafer.

## Patentansprüche

1. Waferbearbeitungskammer, umfassend:
einen unteren Träger (1011) mit einer Anzahl an tragenden Flächen (1021), wobei der untere Träger (1011) einen ersten Raum (1131) enthält, der zwischen der Anzahl an tragenden Flächen (1021) verteilt ist;
eine durch die Anzahl an tragenden Flächen (1021) des unteren Trägers (1011) getragene Platte (1091), wobei die Platte (1091) über dem ersten Raum (1131) liegt, wobei die Platte (1091) eine Anzahl an Wafer tragenden Flächen (1101) zum Aufnehmen und Tragen eines Wafers (1171) hat, wobei die Platte (1091) einen zweiten Raum (1151) hat, der zwischen der Anzahl an Wafer tragenden Platten (1101) verteilt ist, wobei die Platte (1091) Einlässe (2091) und Auslässe (2091) zur Einführung eines Fluidstroms hat, wobei die Ein- (2091) und Auslässe (2091) in einem Umfang der Platte (1091) und außerhalb einer Stelle, die dazu bestimmt ist, den Wafer (1171) aufzunehmen, begrenzt sind; und
einen über der Platte (1091) liegenden oberen Träger (1031), wobei der obere Träger (1031) an dem unteren Träger (1011) außerhalb eines Umfangs der Platte (1091) angekoppelt ist, wobei der obere Träger (1031) einen dritten Raum (1191) hat, der derart gestaltet ist, dass er über dem Wafer (1171) liegt, der von der Platte (1091) getragen werden soll,
**dadurch gekennzeichnet, dass** die Ein- (2091) und Auslässe (2091) der Platte (1091) derart ausgerichtet sind, dass sie einen Fluidstrom nach einem festgelegten Strömungsbild durch den dritten Raum (1191) leiten, wenn der obere Träger (1031) am unteren Träger (1011) außerhalb des Umfangs der Platte (1091) angekoppelt ist.

2. Waferbearbeitungskammer nach Anspruch 1, wobei der erste Raum (1131) einen Zwischenraum darstellt, der sich zwischen einem mittleren Bereich und einem äußeren Bereich der Waferreinigungskammer (1001) befindet, der zweite Raum (1151) stellt einen in Bezug zum Wafer (1171) darunter liegenden Raum dar, und der dritte Raum (1191) stellt einen in Bezug zum Wafer (1171) darüber liegenden Raum dar.

3. Waferbearbeitungskammer nach Anspruch 1, ferner umfassend:
einen ersten Raumeinlass (2011), über den der erste Raum (1131) mit einem Fluid versorgt wird;
einen ersten Raumauslass (2031) zum Entfernen des Fluids aus dem ersten Raum (1131);
einen zweiten Raumeinlass (2071), über den der zweite Raum (1151) mit einem Fluid versorgt wird; und
einen zweiten Raumauslass (2051) zum Entfernen des Fluids aus dem zweiten Raum (1151).

4. Waferbearbeitungskammer nach Anspruch 1, ferner umfassend:
eine Dichtung (1071), die zwischen dem oberen Träger (1031) und dem unteren Träger (1011) angeordnet ist, wobei die Dichtung (1071) dazu dient,
den dritten Raum (1191) von einer äußeren Umgebung zu isolieren.

5. Verfahren zur Durchführung eines Waferreinigungsprozesses, umfassend:
das Bereitstellen einer Kammer (12A1), umfassend:
- einen ersten Raum (1191), der derart gestaltet ist, dass er über dem Wafer liegt;
- eine Platte (1091) zum Tragen eines Wafers, wobei die Platte (1091) ferner derart gestaltet ist, dass sie einen zweiten Raum (1151) begrenzt, der unmittelbar unterhalb des Wafers liegt, wenn der Wafer auf der Platte (1091) getragen wird, wobei die Platte (1091) Fluideinlässe (209B1) und Fluidauslässe (209A1) umfasst, die in einem Umfang der Platte und außerhalb eines zum Tragen des Wafers bestimmten Teils der Platte begrenzt sind, wobei die Fluideinlässe (209B1) und Fluidauslässe (209A1) derart ausgerichtet sind, dass sie einen Fluidstrom durch den ersten Raum (1191) nach einem festgelegten Strömungsbild leiten;
- eine Trägerstruktur zum Tragen der Platte, wobei die Trägerstruktur ferner derart gestaltet ist, dass sie einen dritten Raum (1131) aufweist, der direkt unterhalb der Platte (1091) liegt;
das Anbringen eines Wafers auf den Teil der Platte (1091), der dazu bestimmt ist, den Wafer zu tragen;
**dadurch gekennzeichnet, dass** das Verfahren ferner folgende Schritte umfasst
das Beaufschlagen (12B, 12C1) des ersten Raums (1191), des zweiten Raums (1151) und des dritten Raums (1131) mit Druck, wobei die Druckbeaufschlagung dazu führt, dass der erste Raum einen höheren Druck aufweist als der zweite Raum (1151), wobei die Druckbeaufschlagung ferner dazu führt, dass der zweite Raum (1151) einen höheren Druck aufweist als der dritte Raum (1131); und
das Versorgen (12D1) des ersten Raums (1191) mit einem Fluid über die Fluideinlässe und das Entfernen des Fluids aus dem ersten Raum (1191) über die Fluidauslässe, wobei das Fluid eine Formulierung aufweist, die einen Reinigungsprozess des Wafers bewirkt.

6. Verfahren zur Durchführung eines Waferreinigungsprozesses nach Anspruch 5, wobei das Fluid ein superkritisches Fluid ist.

7. Verfahren zur Durchführung eines Waferreinigungsprozesses nach Anspruch 5, wobei die Kammer als Teil einer Waferbearbeitung-Cluster-Architektur vorgesehen ist.

8. Verfahren zur Durchführung eines Waferreinigungsprozesses nach Anspruch 5, wobei ein höherer Druck des ersten Raums (1191) relativ zu einem Druck des zweiten Raums (1151) dazu dient, den Wafer auf der Platte zu halten.

9. Verfahren zur Durchführung eines Waferreinigungsprozesses nach Anspruch 5, wobei das festgelegte Fließverhalten des Fluidstroms durch den ersten Raum (1191) ein lineares Fließverhalten, ein konisches Fließverhalten und ein spiralförmiges Fließverhalten ist.

10. Verfahren zur Durchführung eines Waferreinigungsprozesses nach Anspruch 5, wobei die Platte eine Anzahl an tragenden Flächen umfasst, auf denen der Wafer getragen wird, und wobei der zweite Raum (1151) zwischen der Anzahl an die Platte tragenden Flächen und unterhalb des Wafers, wenn der Wafer von der Platte getragen wird, besteht.

11. Verfahren zur Durchführung eines Waferreinigungsprozesses nach Anspruch 10, wobei die Anzahl an tragenden Flächen im Wesentlichen gleichmäßig über den Teil der Platte verteilt ist, der dazu bestimmt ist, den Wafer zu tragen.

## Revendications

1. Une chambre de fabrication de tranche, comprenant :
un support inférieur (1011) ayant un nombre de surfaces de support (1021), le support inférieur (1011) contenant un premier volume (1131) réparti entre le nombre de surfaces de support (1021) ;
une plaque (1091) soutenue par le nombre de surfaces de support (1021) du support inférieur (1011), la plaque (1091) recouvrant le premier volume (1131), la plaque (1091) ayant un nombre de surfaces de support de tranche (1101) pour recevoir et soutenir une tranche (1171), la plaque (1091) ayant un deuxième volume (1151) réparti entre le nombre de surfaces de support de tranche (1101),
la plaque (1091) ayant des entrées (2091) et des sorties (2091) pour introduire un débit de liquide, les entrées (2091) et sorties (2091) étant définies dans une périphérie de la plaque (1091) et à l'extérieur d'un emplacement qui doit recevoir la tranche (1171) ; et
un support supérieur (1031) recouvrant la plaque (1091), le support supérieur (1031) faisant interface avec le support inférieur (1011) à l'extérieur d'une périphérie de la plaque (1091), le support supérieur (1031) ayant un troisième volume (1191) configuré pour recouvrir la tranche (1171) à soutenir par la plaque (1091),
**caractérisé en ce que** les entrées (2091) et les sorties (2091) de la plaque (1091) sont orientées pour diriger un débit de liquide au travers du troisième volume (1191) dans une configuration établie lorsque le support supérieur (1031) fait interface avec le support inférieur (1011) à l'extérieur de la périphérie de la plaque (1091).

2. Une chambre de fabrication de tranche comme revendiqué dans la revendication 1, où le premier volume (1131) représente un volume intermédiaire situé entre une région centrale et une région extérieure de la chambre de nettoyage de tranche (1001), le deuxième volume (1151) représente un volume sous-jacent en ce qui concerne la tranche (1171), et le troisième volume (1191) représente un volume recouvrant pour ce qui est de la tranche (1171).

3. Une chambre de fabrication de tranche comme revendiqué dans la revendication 1, comprenant également :
une première entrée de volume (2011) pour fournir un liquide au premier volume (1131) ;
une première sortie de volume (2031) pour supprimer le liquide du premier volume (1131) ;
une deuxième entrée de volume (2071) pour fournir un liquide au deuxième volume (1151) ; et
une deuxième sortie de volume (2051) pour supprimer le liquide du deuxième volume (1151).

4. Une chambre de fabrication de tranche comme revendiqué dans la revendication 1, comprenant également :
un joint (1071) disposé entre le support supérieur (1031) et le support inférieur (1011), le joint (1071) servant à isoler le troisième volume (1191) d'un environnement extérieur.

5. Une méthode pour réaliser un processus de nettoyage de tranche, comprenant :
le fait de fournir une chambre (12A1), comprenant,
- un premier volume (1191) configuré pour recouvrir une tranche ;
- une plaque (1091) configurée pour soutenir une tranche, la plaque (1091) étant de plus configurée pour définir un deuxième volume (1151) directement sous la tranche lorsque la tranche est soutenue sur la plaque (1091), la plaque (1091) incluant des entrées de liquide (209B1) et des sorties de liquide (209A1) définie dans une périphérie de la plaque et à l'extérieur d'une portion de la plaque définie pour soutenir la tranche, les entrées de liquide (209B1) et les sorties de liquide (209A1) orientées pour diriger un débit de liquide au travers du premier volume (1191) dans un modèle défini ;
- une structure de support configurée pour soutenir la plaque, la structure de support configurée de plus pour définir un troisième volume (1131) directement sous la plaque (1091) ;
en plaçant une tranche sur la portion de la plaque (1091) définie pour soutenir la tranche ;
**caractérisée en ce que** la méthode comprend de plus
une pressurisation (12B, 12C1) du premier volume (1191), du deuxième volume (1151), et du troisième volume (1131), la pressurisation entraînant le premier volume à avoir une pression supérieure au deuxième volume (1151), la pressurisation entraînant de plus le deuxième volume (1151) à avoir une pression supérieure au troisième volume (1131) ; et
le fait de fournir (12D1) un liquide au premier volume (1191) au travers des entrées de liquide et la suppression du liquide à partir du premier volume (1191) au travers des sorties de liquide, le liquide étant formulé pour effectuer un processus de nettoyage de tranche.

6. Une méthode pour effectuer un processus de nettoyage de tranche comme revendiqué dans la revendication 5, où le liquide est un liquide super critique.

7. Une méthode pour effectuer un processus de nettoyage de tranche comme revendiqué dans la revendication 5, où la chambre est fournie comme partie d'une architecture en grappe de fabrication de tranche.

8. Une méthode pour effectuer un processus de nettoyage de tranche comme revendiqué dans la revendication 5, où une pression supérieure du premier volume (1191) relative à une pression du deuxième volume (1151) serve à maintenir la tranche sur la plaque.

9. Une méthode pour effectuer un processus de nettoyage de tranche comme revendiqué dans la revendication 5, où le modèle établi du débit de liquide au travers du premier volume (1191) est un modèle de débit linéaire, un modèle de débit conique, et un modèle de débit en spirale.

10. Une méthode pour effectuer un processus de nettoyage de tranche comme revendiqué dans la revendication 5, où la plaque inclut un nombre de surfaces de support sur lequel la tranche est soutenue, et où le deuxième volume (1151) existe entre le nombre de surfaces de support de la plaque et sous la tranche lorsque la tranche est soutenue sur la plaque.

11. Une méthode pour effectuer un processus de nettoyage de tranche comme revendiqué dans la revendication 10, où le nombre de surfaces de support est distribué de façon principalement uniforme sur la portion de la plaque définie pour soutenir la tranche.
